# EUROPEAN PATENT APPLICATION

(11) **EP 4 687 133 A1**
(43) Date of publication of application: **04.02.2026**
(21) Application number: 25191616.9
(22) Date of filing: 24.07.2025
(51) Int. Cl.: G09G 3/32

(54) **SCAN DRIVER AND ELECTRONIC DEVICE**

(30) Priority: 29.07.2024 KR 20240100222; 23.01.2025 KR 20250010092
(71) Applicant: Samsung Display Co., Ltd., Yongin-si, Gyeonggi-do 17113 (KR)
(72) Inventor: SEO, Youngwan, Yongin-si (KR); AN, Jongyeop, Yongin-si (KR)
(74) Representative: Marks & Clerk LLP

(57) **Abstract**

A scan driver including stages, at least one stage including a logic circuit configured to control a voltage of a first node and a voltage of a second node based on an input signal, a first clock signal, and a second clock signal in a progressive driving period, an output circuit configured to receive the first clock signal and a concurrent driving signal, and to output a scan signal in response to the voltage of the first node and the voltage of the second node, and a concurrent driving circuit configured to control the voltage of the first node and the voltage of the second node in response to an inverted concurrent driving signal in a concurrent driving period such that the output circuit is configured to output the concurrent driving signal as the scan signal in the concurrent driving period.

## Description

### BACKGROUND

### 1. Field

Embodiments of the present disclosure relate to a scan driver, and an electronic device including the scan driver.

### 2. Description of the Related Art

A scan driver of a display device may sequentially provide scan signals to a plurality of pixels of a display panel on a row-by-row basis. To sequentially provide the scan signals on the row-by-row basis, the scan driver may be implemented as a shift register including a plurality of stages.

In a case where the pixels of the display device include N-type metal-oxide-semiconductor ("NMOS") transistors, the scan driver also may be implemented with NMOS transistors to generate active high scan signals for turning on the NMOS transistors of the pixels. However, if the scan driver includes the NMOS transistors, leakage currents through the NMOS transistors may occur, and the scan driver may not operate normally.

### SUMMARY

Some embodiments provide a scan driver having improved reliability.

Some embodiments provide an electronic device including the scan driver.

According to embodiments, there is provided a scan driver including stages, at least one stage of the stages including a logic circuit configured to control a voltage of a first node and a voltage of a second node based on an input signal, a first clock signal, and a second clock signal in a progressive driving period, an output circuit configured to receive the first clock signal and a concurrent driving signal, and to output a scan signal in response to the voltage of the first node and the voltage of the second node, and a concurrent driving circuit configured to control the voltage of the first node and the voltage of the second node in response to an inverted concurrent driving signal in a concurrent driving period such that the output circuit is configured to output the concurrent driving signal as the scan signal in the concurrent driving period.

The concurrent driving signal may have a first low gate voltage in the progressive driving period, and may have a high gate voltage in the concurrent driving period, and wherein the inverted concurrent driving signal has the high gate voltage in the progressive driving period, and has a second low gate voltage that is lower than the first low gate voltage in the concurrent driving period.

The concurrent driving signal may be changed from the high gate voltage to the first low gate voltage at a start time point of the progressive driving period, wherein, within the progressive driving period, the inverted concurrent driving signal is changed from the second low gate voltage to the high gate voltage after the concurrent driving signal is changed to the first low gate voltage.

In the concurrent driving period, the concurrent driving circuit may be configured to apply a first low gate voltage to the first node, and a high gate voltage to the second node, in response to the inverted concurrent driving signal, and the output circuit may be configured to output the concurrent driving signal having the high gate voltage as the scan signal.

In the progressive driving period, the logic circuit may be configured to control the voltage of the first node to a high level, and configured to control the voltage of the second node to a low level, when the first clock signal has the low level and the input signal has the high level, and the output circuit may be configured to output the first clock signal as the scan signal in response to the voltage of the first node having the high level and the voltage of the second node having the low level.

All transistors in the at least one stage may include P-type metal-oxide-semiconductor (PMOS) transistors.

The concurrent driving circuit may include a first transistor including a gate configured to receive the inverted concurrent driving signal, a first terminal configured to receive a first low gate voltage, and a second terminal connected to the first node.

The concurrent driving circuit may further include a second transistor including a gate configured to receive the inverted concurrent driving signal, a first terminal configured to receive a high gate voltage, and a second terminal connected to the second node.

The concurrent driving circuit may further include a fourth capacitor including a first electrode connected to the second node, and a second electrode configured to receive the concurrent driving signal.

The output circuit may further include a third transistor including a gate connected to the second node, a first terminal configured to receive the first clock signal, and a second terminal connected to an output node configured to output the scan signal, and a fourth transistor including a gate connected to the first node, a first terminal connected to the output node, and a second terminal configured to receive the concurrent driving signal.

The logic circuit may include an input circuit configured to transfer the input signal to a third node in response to the first clock signal, a node-separating circuit between the third node and the first node, a boosting circuit configured to boost the voltage of the first node based on the second clock signal, and a node control circuit configured to control the voltage of the second node based on the first clock signal, the second clock signal, the voltage of the first node, and the concurrent driving signal.

The input circuit may include a fifth transistor including a gate configured to receive the first clock signal, a first terminal configured to receive the input signal, and a second terminal connected to the third node.

The node-separating circuit may include a sixth transistor including a gate configured to receive the concurrent driving signal, a first terminal connected to the third node, and a second terminal connected to the first node.

The boosting circuit may include a seventh transistor including a gate connected to the first node, a first terminal, and a second terminal configured to receive the second clock signal, and a first capacitor including a first electrode connected to the first terminal of the seventh transistor, and a second electrode connected to the first node.

The node control circuit may include an eighth transistor including a gate configured to receive the first clock signal, a first terminal configured to receive the concurrent driving signal, and a second terminal connected to a fourth node, a ninth transistor including a gate connected to the first node, a first terminal configured to receive the first clock signal, and a second terminal connected to the fourth node, a tenth transistor including a gate configured to receive a first low gate voltage, a first terminal connected to the fourth node, and a second terminal connected to a fifth node, a second capacitor including a first electrode connected to the fifth node, and a second electrode connected to a sixth node, an eleventh transistor including a gate connected to the fifth node, a first terminal connected to the sixth node, and a second terminal, a twelfth transistor including a gate connected to the fifth node, a first terminal connected to the second terminal of the eleventh transistor, and a second terminal configured to receive the second clock signal, a thirteenth transistor including a gate configured to receive the second clock signal, a first terminal connected to the sixth node, and a second terminal connected to the second node, a third capacitor including a first electrode configured to receive the first clock signal, and a second electrode connected to the second node, and a fourteenth transistor including a gate connected to the first node, a first terminal configured to receive the first clock signal, and a second terminal connected to the second node.

The at least one stage may further include a reset circuit configured to transfer the first clock signal to the first node in response to a reset signal, and to transfer the concurrent driving signal to the second node in response to the reset signal.

The reset circuit may include a fifteenth transistor including a gate configured to receive the reset signal, a first terminal configured to receive the first clock signal, and a second terminal connected to a third node, and a sixteenth transistor including a gate configured to receive the reset signal, a first terminal connected to the second node, and a second terminal configured to receive the concurrent driving signal.

According to embodiments, there is provided a scan driver including stages, at least one stage of the stages including a logic circuit configured to receive an input signal, a first clock signal, a second clock signal, and a concurrent driving signal, and connected to a first node and to a second node, a first transistor including a gate configured to receive an inverted concurrent driving signal, a first terminal configured to receive a first low gate voltage, and a second terminal connected to the first node, a second transistor including a gate configured to receive the inverted concurrent driving signal, a first terminal configured to receive a high gate voltage, and a second terminal connected to the second node, a third transistor including a gate connected to the second node, a first terminal configured to receive the first clock signal, and a second terminal connected to an output node configured to output a scan signal, and a fourth transistor including a gate connected to the first node, a first terminal connected to the output node, and a second terminal configured to receive the concurrent driving signal.

The logic circuit may include a fifth transistor including a gate configured to receive the first clock signal, a first terminal configured to receive the input signal, and a second terminal connected to a third node, a sixth transistor including a gate configured to receive the concurrent driving signal, a first terminal connected to the third node, and a second terminal connected to the first node, a seventh transistor including a gate connected to the first node, a first terminal, and a second terminal configured to receive the second clock signal, a first capacitor including a first electrode connected to the first terminal of the seventh transistor, and a second electrode connected to the first node, an eighth transistor including a gate configured to receive the first clock signal, a first terminal configured to receive the concurrent driving signal, and a second terminal connected to a fourth node, a ninth transistor including a gate connected to the first node, a first terminal configured to receive the first clock signal, and a second terminal connected to the fourth node, a tenth transistor including a gate configured to receive the first low gate voltage, a first terminal connected to the fourth node, and a second terminal connected to a fifth node, a second capacitor including a first electrode connected to the fifth node, and a second electrode connected to a sixth node, an eleventh transistor including a gate connected to the fifth node, a first terminal connected to the sixth node, and a second terminal, a twelfth transistor including a gate connected to the fifth node, a first terminal connected to the second terminal of the eleventh transistor, and a second terminal configured to receive the second clock signal, a thirteenth transistor including a gate configured to receive the second clock signal, a first terminal connected to the sixth node, and a second terminal connected to the second node, a third capacitor including a first electrode configured to receive the first clock signal, and a second electrode connected to the second node, and a fourteenth transistor including a gate connected to the first node, a first terminal configured to receive the first clock signal, and a second terminal connected to the second node.

According to embodiments, there is provided an electronic device including a processor configured to provide input image data, and a display device configured to receive the input image data from the processor, and to display an image based on the input image data, the display device including a display panel including pixels, a data driver configured to provide data signals to the pixels, a scan driver including stages configured to provide scan signals to the pixels, an emission driver configured to provide emission signals to the pixels, and a controller configured to control the data driver, the scan driver and the emission driver, wherein at least one stage of the stages includes a logic circuit configured to control a voltage of a first node and a voltage of a second node based on an input signal, a first clock signal, and a second clock signal in a progressive driving period, an output circuit configured to receive the first clock signal and a concurrent driving signal, and to output a scan signal in response to the voltage of the first node and the voltage of the second node, and a concurrent driving circuit configured to control the voltage of the first node and the voltage of the second node in response to an inverted concurrent driving signal in a concurrent driving period such that the output circuit is configured to output the concurrent driving signal as the scan signal in the concurrent driving period.

As described above, in a scan driver and an electronic device according to embodiments, the scan driver may generate scan signals for turning on NMOS transistors of pixels of a display device by using PMOS transistors.

Further, in the scan driver and the electronic device according to embodiments, the scan driver may sequentially provide scan signals to a plurality of pixels on a row-by-row basis in a progressive driving period, and may substantially simultaneously provide the scan signals to the plurality of pixels in a concurrent/simultaneous driving period.
At least some of the above and other features of the invention are set out in the claims.

### BRIEF DESCRIPTION OF THE DRAWINGS

Illustrative, non-limiting embodiments will be more clearly understood from the following detailed description in conjunction with the accompanying drawings.
FIG. 1 is a block diagram illustrating a scan driver according to embodiments.
FIG. 2 is a timing diagram for describing an example of an operation of a scan driver in a progressive driving period.
FIG. 3 is a timing diagram for describing an example of an operation of a scan driver in a concurrent/simultaneous driving period.
FIG. 4 is a circuit diagram illustrating a stage of a scan driver according to embodiments.
FIG. 5 is a timing diagram for describing an example of an operation of a stage of FIG. 4 in a progressive driving period.
FIG. 6 is a circuit diagram for describing an example of an operation of a stage of FIG. 4 in a first time period.
FIG. 7 is a circuit diagram for describing an example of an operation of a stage of FIG. 4 in a second time period.
FIG. 8 is a circuit diagram for describing an example of an operation of a stage of FIG. 4 in a third time period.
FIG. 9 is a timing diagram for describing an example of an operation of a stage of FIG. 4 in a concurrent/simultaneous driving period.
FIG. 10 is a circuit diagram for describing an example of an operation of a stage of FIG. 4 in a concurrent/simultaneous driving period.
FIG. 11 is a timing diagram for describing an example of a scan signal at a time point at which a concurrent/simultaneous driving period ends and a progressive driving period starts.
FIG. 12 is a circuit diagram illustrating a stage of a scan driver according to embodiments.
FIG. 13 is a circuit diagram illustrating a stage of a scan driver according to embodiments.
FIG. 14 is a circuit diagram illustrating a stage of a scan driver according to embodiments.
FIG. 15 is a block diagram illustrating a display device according to embodiments.
FIG. 16 is a circuit diagram illustrating an example of a pixel included in a display device according to embodiments.
FIG. 17 is a timing diagram illustrating an example of a frame period of a display device.
FIG. 18 is a block diagram illustrating an electronic device including a display device according to embodiments.
FIG. 19 is a block diagram illustrating an example of an electronic device according to embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection.

For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure as defined in the claims. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same". In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

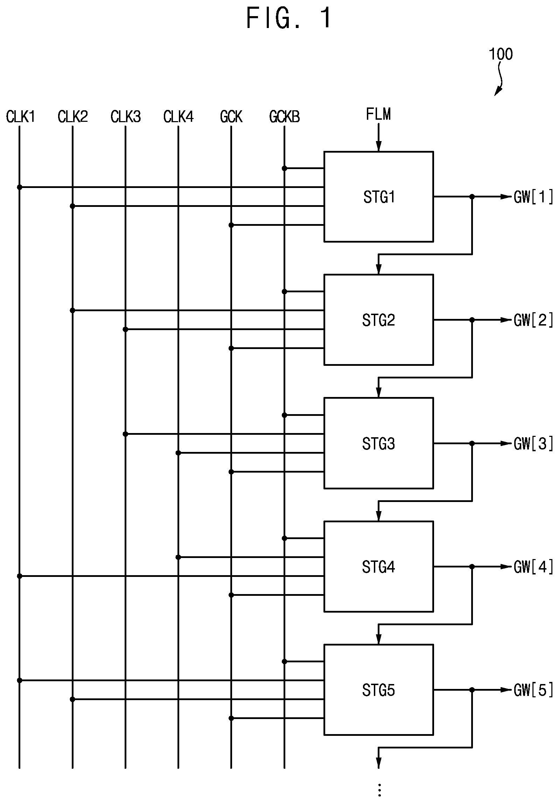

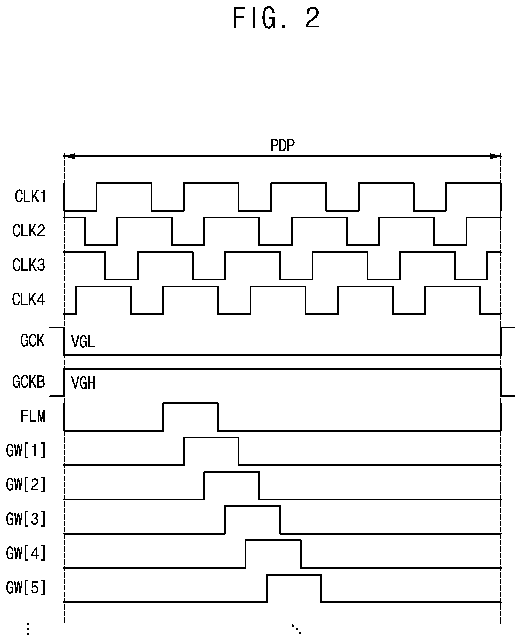

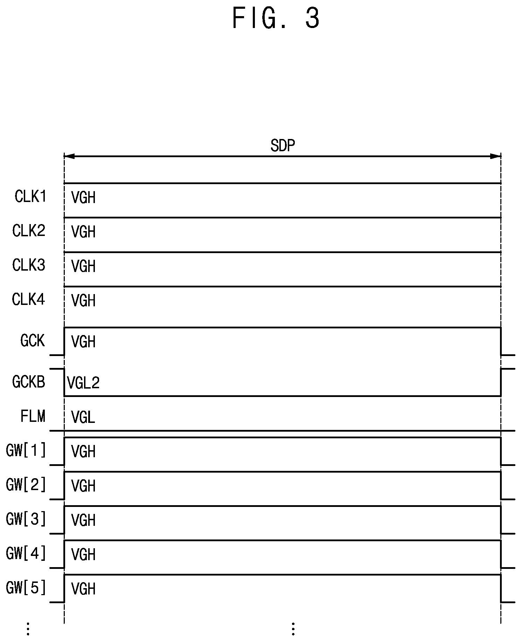

FIG. 1 is a block diagram illustrating a scan driver according to embodiments, FIG. 2 is a timing diagram for describing an example of an operation of a scan driver in a progressive driving period, and FIG. 3 is a timing diagram for describing an example of an operation of a scan driver in a concurrent driving period/ simultaneous driving period/substantially simultaneous driving period (hereinafter, concurrent driving period).

Referring to FIG. 1, a scan driver 100 according to embodiments may include a plurality of stages STG1, STG2, STG3, STG4, STG5, etc. The scan driver 100 may be implemented as a shift register in which the plurality of stages STG1, STG2, STG3, STG4, STG5, etc. sequentially outputs scan signals GW[1], GW[2], GW[3], GW[4], GW[5], etc., respectively.

Among the plurality of stages STG1, STG2, STG3, STG4, STG5, etc., a first stage STG1 may receive a start signal FLM as an input signal, and each of subsequent stages STG2, STG3, STG4, STG5, etc. may receive a scan signal of a previous stage as an input signal. For example, a second stage STG2 may receive a first scan signal GW[1] of the first stage STG1 as an input signal, a third stage STG3 may receive a second scan signal GW[2] of the second stage STG2 as an input signal, a fourth stage STG4 may receive a third scan signal GW[3] of the third stage STG3 as an input signal, and a fifth stage STG5 may receive a fourth scan signal GW[4] of the fourth stage STG4 as an input signal.

The plurality of stages STG1, STG2, STG3, STG4, STG5, etc. may receive a first clock signal CLK1, a second clock signal CLK2, a third clock signal CLK3, and a fourth clock signal CLK4 having different respective phases. In some embodiments, each of the first through fourth clock signals CLK1 through CLK4 may have a period (or a clock cycle) corresponding to, but not limited to, four horizontal times. Here, one horizontal time may be a time allocated to each pixel row of a display panel, and may be determined by dividing one frame period by the number of pixel rows of the display panel. Further, in some embodiments, as illustrated in FIG. 2, the second clock signal CLK2 may be delayed or shifted from by one horizontal time the first clock signal CLK1, the third clock signal CLK3 may be delayed or shifted by one horizontal time from the second clock signal CLK2, the fourth clock signal CLK4 may be delayed or shifted by one horizontal time from the third clock signal CLK3, and the first clock signal CLK1 may be delayed or shifted by one horizontal time from the fourth clock signal CLK4.

In some embodiments, each stage STG1, STG2, STG3, STG4, STG5, etc. may receive two adjacent clock signals among the first through fourth clock signals CLK1 through CLK4. For example, as illustrated in FIG. 1, a (4N+1)-th stage STG1, STG5, etc. may receive the first clock signal CLK1 and the second clock signal CLK2, a (4N+2)-th stage STG2, etc. may receive the second clock signal CLK2 and the third clock signal CLK3, a (4N+3)-th stage STG3, etc. may receive the third clock signal CLK3 and the fourth clock signal CLK4, and a (4N+4)-th stage STG4, etc. may receive the fourth clock signal CLK4 and the first clock signal CLK1, where N is an integer that is greater than or equal to 0.

The scan driver 100 according to embodiments may sequentially output the scan signals GW[1], GW[2], GW[3], GW[4], GW[5], etc. in a progressive driving period (or a sequential driving period), and also may substantially simultaneously output the scan signals GW[1], GW[2], GW[3], GW[4], GW[5], etc. in a concurrent driving period. To perform an operation in the progressive driving period and an operation in the concurrent driving period, the plurality of stages STG1, STG2, STG3, STG4, STG5, etc. may further receive a concurrent driving signal/simultaneous driving signal/substantially simultaneous driving signal (hereinafter referred to as a concurrent driving signal) GCK and an inverted concurrent driving signal GCKB.

For example, as illustrated in FIG. 2, in the progressive driving period PDP, the first through fourth clock signals CLK1 through CLK4 may periodically toggle between a high level and a low level, the concurrent driving signal GCK may have a low level, and the inverted concurrent driving signal GCKB may have a high level. In some embodiments, in the progressive driving period PDP, the concurrent driving signal GCK may have a first low gate voltage VGL, and the inverted concurrent driving signal GCKB may have a high gate voltage VGH. Further, based on the first through fourth clock signals CLK1 through CLK4, the concurrent driving signal GCK and the inverted concurrent driving signal GCKB, the first stage STG1 may output the first scan signal GW[1] by delaying or shifting the start signal FLM by one horizontal time, the second stage STG2 may output the second scan signal GW[2] by delaying or shifting the first scan signal GW[1] by one horizontal time, the third stage STG3 may output the third scan signal GW[3] by delaying or shifting the second scan signal GW[2] by one horizontal time, the fourth stage STG4 may output the fourth scan signal GW[4] by delaying or shifting the third scan signal GW[3] by one horizontal time, and a fifth stage STG5 may output a fifth scan signal GW[5] by delaying or shifting the fourth scan signal GW[4] by one horizontal time.

Further, as illustrated in FIG. 3, in the concurrent driving period SDP, the first through fourth clock signals CLK1 through CLK4 may be maintained at a high level or the high gate voltage VGH, the concurrent driving signal GCK may have a high level, and the inverted concurrent driving signal GCKB may have a low level. In some embodiments, in the concurrent driving period SDP, the concurrent driving signal GCK may have the high gate voltage VGH, and the inverted concurrent driving signal GCKB may have a second low gate voltage VGL2 that is lower than the first low gate voltage VGL. Further, based on the first through fourth clock signals CLK1 through CLK4, the concurrent driving signal GCK and the inverted concurrent driving signal GCKB, the plurality of stages STG1, STG2, STG3, STG4, STG5, etc. may substantially simultaneously output the scan signals GW[1], GW[2], GW[3], GW[4], GW[5], etc. having a high level or the high gate voltage VGH.

As described above, the scan driver 100 according to embodiments may sequentially output the scan signals GW[1], GW[2], GW[3], GW[4], GW[5], etc. having a high level or the high gate voltage VGH in the progressive driving period PDP, and may substantially simultaneously output the scan signals GW[1], GW[2], GW[3], GW[4], GW[5], etc. having the high level or the high gate voltage VGH in the concurrent driving period SDP.

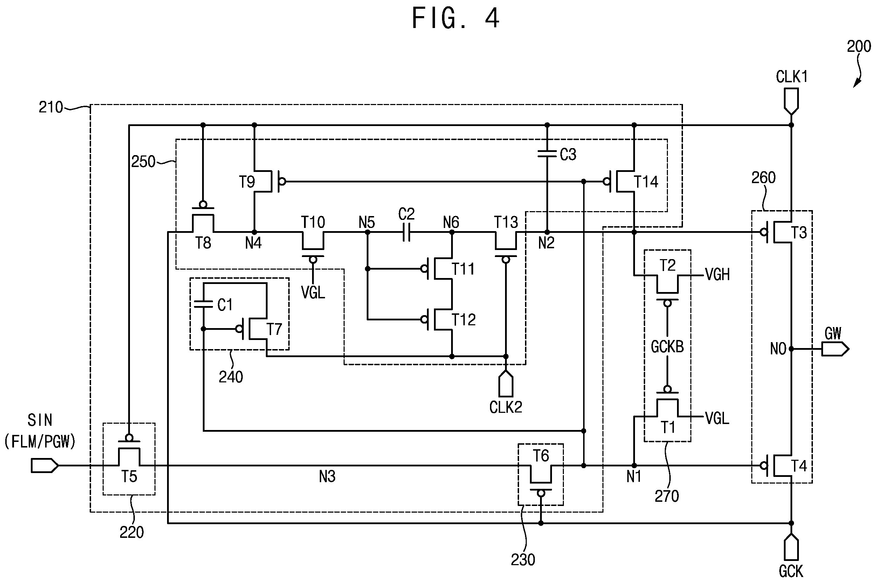

FIG. 4 is a circuit diagram illustrating a stage of a scan driver according to embodiments.

Referring to FIG. 4, a stage 200 of a scan driver according to embodiments may include a logic circuit 210 that controls a voltage of a first node N1 and a voltage of a second node N2 in a progressive driving period, an output circuit 260 that outputs a scan signal GW in response to the voltage of the first node N1 and the voltage of the second node N2, and a concurrent driving circuit/simultaneous driving circuit/substantially simultaneous driving circuit (hereinafter, concurrent driving circuit) 270 that controls the voltage of the first node N1 and the voltage of the second node N2 in a concurrent driving period.

The logic circuit 210 may control the voltage of the first node N1 and the voltage of the second node N2 based on an input signal SIN, a first clock signal CLK1, and a second clock signal CLK2. In some embodiments, the logic circuit 210 may include an input circuit 220, a node-separating circuit 230, a boosting circuit 240 and a node control circuit 250.

The input circuit 220 may transfer the input signal SIN to a third node N3 in response to the first clock signal CLK1. The input signal SIN may be a start signal FLM in a case where the stage 200 is a first stage of the scan driver, and may be a scan signal PGW of a previous stage in a case where the stage 200 is a stage subsequent to the first stage. Although FIG. 4 illustrates an example in which the stage 200 is a (4N+1)-th stage, and in which the input circuit 220 receives the first clock signal CLK1, the input circuit 220 of a (4N+2)-th stage may receive the second clock signal CLK2 instead of the first clock signal CLK1, the input circuit 220 of a (4N+3)-th stage may receive the third clock signal CLK3 illustrated in FIG. 1 instead of the first clock signal CLK1, and the input circuit 220 of a (4N+4)-th stage may receive the fourth clock signal CLK4 illustrated in FIG. 1 instead of the first clock signal CLK1.

In some embodiments, the input circuit 220 may include a fifth transistor T5. The fifth transistor T5 may include a gate that receives the first clock signal CLK1, a first terminal that receives the input signal SIN, and a second terminal connected to the third node N3.

The node-separating circuit 230 may be connected between the third node N3 and the first node N1. The node-separating circuit 230 may connect the third node N3 and the first node N1 to each other (e.g., in most times, and/or a majority of an operation time), but may separate the third node N3 and the first node N1 from each other when the voltage of the first node N1 is boosted by the boosting circuit 240.

In some embodiments, the node-separating circuit 230 may include a sixth transistor T6 that is turned on in response to a concurrent driving signal GCK. The sixth transistor T6 may include a gate that receives the concurrent driving signal GCK, a first terminal connected to the third node N3, and a second terminal connected to the first node N1.

The boosting circuit 240 may boost the voltage of the first node N1 based on the second clock signal CLK2. For example, when the voltage of the first node N1 has a low level, and when the second clock signal CLK2 changes from a high level to a low level, the boosting circuit 240 may boost the voltage of the first node N1 to a boosted low level. Although FIG. 4 illustrates an example in which the stage 200 is the (4N+1)-th stage and the boosting circuit 240 receives the second clock signal CLK2, the boosting circuit 240 of the (4N+2)-th stage may receive the third clock signal CLK3 illustrated in FIG. 1 instead of the second clock signal CLK2, the boosting circuit 240 of the (4N+3)-th stage may receive the fourth clock signal CLK4 illustrated in FIG. 1 instead of the second clock signal CLK2, and the boosting circuit 240 of the (4N+4)-th stage may receive the first clock signal CLK1 instead of the second clock signal CLK2.

In some embodiments, the boosting circuit 240 may include a seventh transistor T7 and a first capacitor C1. The seventh transistor T7 may include a gate connected to the first node N1, a first terminal, and a second terminal that receives the second clock signal CLK2. The first capacitor C1 may include a first electrode connected to the first terminal of the seventh transistor T7, and a second electrode connected to the first node N1.

The node control circuit 250 may control the voltage of the second node N2 based on the first clock signal CLK1, the second clock signal CLK2, the voltage of the first node N1, and the concurrent driving signal GCK. In some embodiments, the node control circuit 250 may include an eighth transistor T8, a ninth transistor T9, a tenth transistor T10, a second capacitor C2, an eleventh transistor T11, a twelfth transistor T12, a thirteenth transistor T13, a third capacitor C3, and a fourteenth transistor T14.

The eighth transistor T8 may transfer the concurrent driving signal GCK to a fourth node N4 in response to the first clock signal CLK1. For example, the eighth transistor T8 may include a gate that receives the first clock signal CLK1, a first terminal that receives the concurrent driving signal GCK, and a second terminal connected to the fourth node N4.

The ninth transistor T9 may transfer the first clock signal CLK1 to the fourth node N4 in response to the voltage of the first node N1. For example, the ninth transistor T9 may include a gate connected to the first node N1, a first terminal that receives the first clock signal CLK1, and a second terminal connected to the fourth node N4.

The tenth transistor T10 may be turned on in response to a first low gate voltage VGL, and may connect the fourth node N4 and a fifth node N5 to each other. For example, the tenth transistor T10 may include a gate that receives the first low gate voltage VGL, a first terminal connected to the fourth node N4, and a second terminal connected to the fifth node N5.

The second capacitor C2 may be connected between the fifth node N5 and a sixth node N6. For example, the second capacitor C2 may include a first electrode connected to the fifth node N5, and a second electrode connected to the sixth node N6.

The eleventh and twelfth transistors T11 and T12 may transfer the second clock signal CLK2 to the sixth node N6 in response to a voltage of the fifth node N5. For example, the eleventh transistor T11 may include a gate connected to the fifth node N5, a first terminal connected to the sixth node N6, and a second terminal, and the twelfth transistor T12 may include a gate connected to the fifth node N5, a first terminal connected to the second terminal of the eleventh transistor T11, and a second terminal that receives the second clock signal CLK2.

The thirteenth transistor T13 may connect the sixth node N6 and the second node N2 to each other in response to the second clock signal CLK2. For example, the thirteenth transistor T13 may include a gate that receives the second clock signal CLK2, a first terminal connected to the sixth node N6, and a second terminal connected to the second node N2.

The third capacitor C3 may be connected between a line that transfers the first clock signal CLK1 and the second node N2. For example, the third capacitor C3 may include a first electrode that receives the first clock signal CLK1, and a second electrode connected to the second node N2.

The fourteenth transistor T14 may transfer the first clock signal CLK1 to the second node N2 in response to the voltage of the first node N1. For example, the fourteenth transistor T14 may include a gate connected to the first node N1, a first terminal that receives the first clock signal CLK1, and a second terminal connected to the second node N2.

The output circuit 260 may receive the first clock signal CLK1 and the concurrent driving signal GCK, and may output the scan signal GW in response to the voltage of the first node N1 and the voltage of the second node N2. For example, the output circuit 260 may output the concurrent driving signal GCK as the scan signal GW when the voltage of the first node N1 has a low level, and may output the first clock signal CLK1 as the scan signal GW when the voltage of the second node N2 has a low level.

In some embodiments, the output circuit 260 may include a third transistor T3 and a fourth transistor T4. The third transistor T3 may include a gate connected to the second node N2, a first terminal that receives the first clock signal CLK1, and a second terminal connected to an output node NO from which the scan signal GW is output. The fourth transistor T4 may include a gate connected to the first node N1, a first terminal connected to the output node NO, and a second terminal that receives the concurrent driving signal GCK.

The concurrent driving circuit 270 may control the voltage of the first node N1 and the voltage of the second node N2 in response to an inverted concurrent driving signal GCKB (or an inverted signal of the concurrent driving signal GCK), such that the output circuit 260 may output the concurrent driving signal GCK as the scan signal GW in the concurrent driving period. For example, in the concurrent driving period, the concurrent driving circuit 270 may control the voltage of the first node N1 to a low level by applying the first low gate voltage VGL to the first node N1, and may control the voltage of the second node N2 to a high level by applying a high gate voltage VGH to the second node N2.

In some embodiments, the concurrent driving circuit 270 may include a first transistor T1 that applies the first low gate voltage VGL to the first node N1. The first transistor T1 may include a gate that receives the inverted concurrent driving signal GCKB, a first terminal that receives the first low gate voltage VGL, and a second terminal connected to the first node N1. In some embodiments, the concurrent driving circuit 270 may further include a second transistor T2 that applies the high gate voltage VGH to the second node N2. The second transistor T2 may include a gate that receives the inverted concurrent driving signal GCKB, a first terminal that receives the high gate voltage VGH, and a second terminal connected to the second node N2.

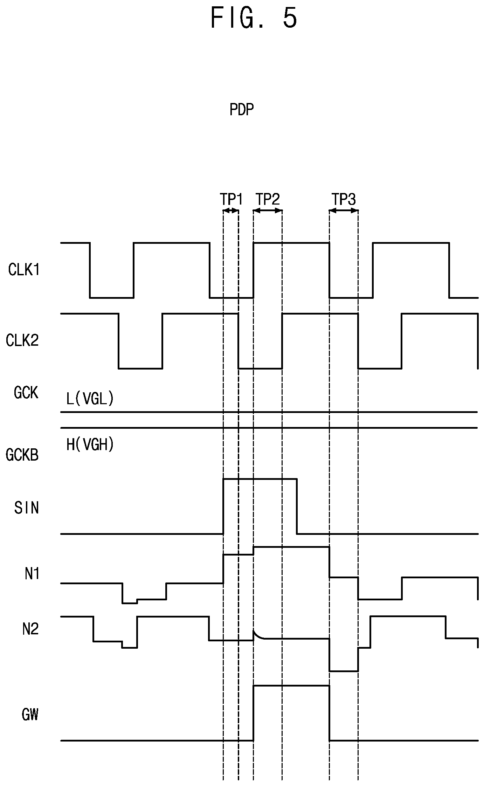

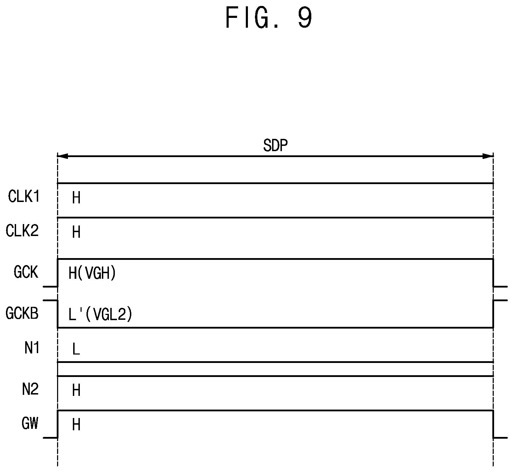

In some embodiments, all transistors included in the stage 200, or the first through fourteenth transistors T1 through T14 may be P-type metal-oxide-semiconductor ("PMOS") transistors. Further, as illustrated in FIGS. 5 and 9, the stage 200 may output the scan signal GW having a high level or the high gate voltage VGH for turning on an N-type metal-oxide-semiconductor ("NMOS") transistor of a pixel. That is, the stage 200 may generate an active high scan signal GW for turning on the NMOS transistor of the pixel by using the PMOS transistors. This effectively averts the problem discussed above, in which usage of NMOS transistors in a scan driver can cause leakage currents and thereby interfere with normal operation.

Further, the stage 200 may generate the scan signal GW having the high level or the high gate voltage VGH by delaying or shifting the input signal SIN in the progressive driving period, and may generate the scan signal GW having the high level or the high gate voltage VGH regardless of (or independently of) the input signal SIN in the concurrent driving period. An operation of the stage 200 in the progressive driving period will be described below with reference to FIGS. 4 through 8, and an operation of the stage 200 in the concurrent driving period will be described below with reference to FIGS. 4 and 9 through 11.

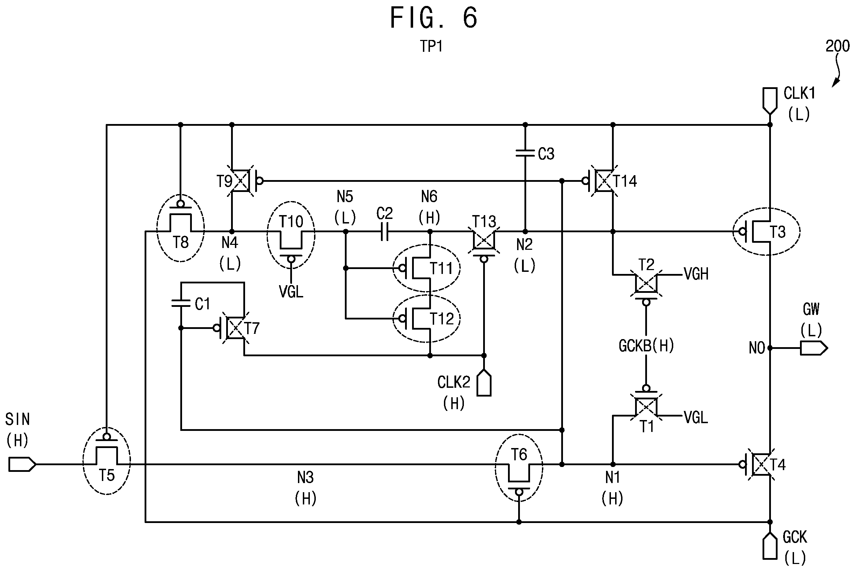

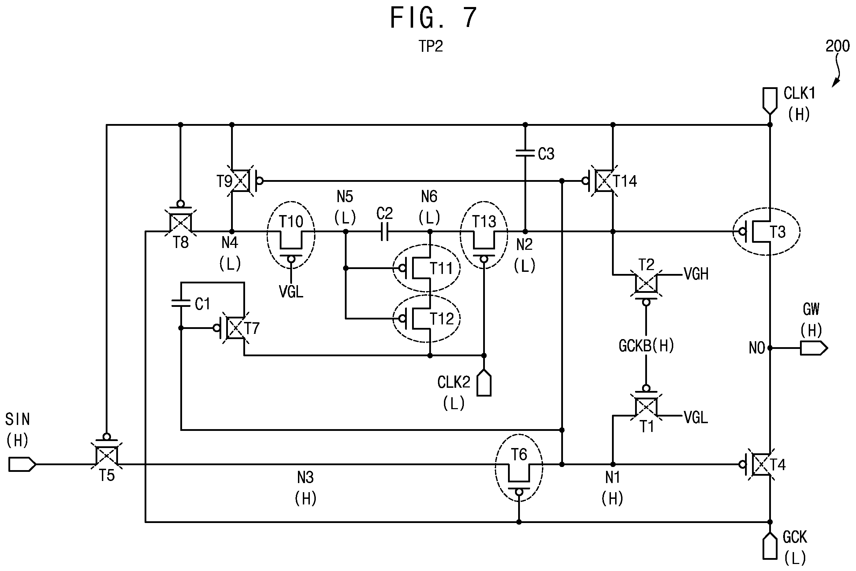

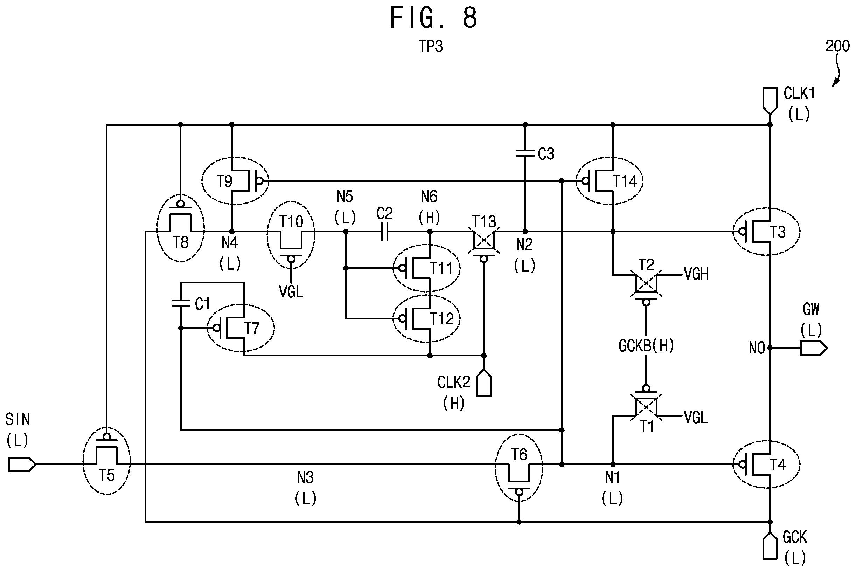

FIG. 5 is a timing diagram for describing an example of an operation of a stage of FIG. 4 in a progressive driving period, FIG. 6 is a circuit diagram for describing an example of an operation of a stage of FIG. 4 in a first time period, FIG. 7 is a circuit diagram for describing an example of an operation of a stage of FIG. 4 in a second time period, and FIG. 8 is a circuit diagram for describing an example of an operation of a stage of FIG. 4 in a third time period.

Referring to FIGS. 4 and 5, in the progressive driving period PDP, the first and second clock signals CLK1 and CLK2 may periodically toggle between a high level H and a low level L, the concurrent driving signal GCK may have a first low gate voltage VGL as the low level L, and the inverted concurrent driving signal GCKB may have a high gate voltage VGH as the high level H. As illustrated in FIGS. 6 to 8, the first transistor T1 and the second transistor T2 may be turned off in response to the inverted concurrent driving signal GCKB having the high level H during the progressive driving period PDP, and thus the concurrent driving circuit 270 may not control the voltage of the first node N1 and the voltage of the second node N2 during the progressive driving period PDP.

Further, in the progressive driving period PDP, the stage 200 may output the scan signal GW having the high level H by delaying or shifting the input signal SIN having the high level H based on the first and second clock signals CLK1 and CLK2, the concurrent driving signal GCK, and the inverted concurrent driving signal GCKB. For example, when the first clock signal CLK1 has the low level L, and when the input signal SIN has the high level H, the logic circuit 210 may control the voltage of the first node N1 to the high level H, and may control the voltage of the second node N2 to the low level L. The output circuit 260 may output the first clock signal CLK1 as the scan signal GW in response to the voltage of the first node N1 having the high level H and the voltage of the second node N2 having the low level L. Thus, the stage 200 may output the scan signal GW having the high level H or the high gate voltage VGH while the voltage of the first node N1 has the high level H, while the voltage of the second node N2 has the low level L, and while the first clock signal CLK1 has the high level H.

For example, referring to FIGS. 5 and 6, in a first time period TP1 in which the input signal SIN has the high level H, in which the first clock signal CLK1 has the low level L, and in which the second clock signal CLK2 has the high level H, the fifth transistor T5 may be turned on in response to the first clock signal CLK1, and may transfer the input signal SIN having the high level H to the third node N3. Thus, the voltage of the third node N3 may have the high level H.

The sixth transistor T6 may be turned on in response to the concurrent driving signal GCK, and may transfer the voltage of the third node N3 to the first node N1. Thus, the voltage of the first node N1 may have the high level H.

The eighth transistor T8 may transfer the concurrent driving signal GCK to the fourth node N4 in response to the first clock signal CLK1, and the tenth transistor T10 may transfer the voltage of the fourth node N4 to the fifth node N5 in response to the first low gate voltage VGL. Thus, the voltages of the fourth and fifth nodes N4 and N5 may have the low level L.

The eleventh and twelfth transistors T11 and T12 may transfer the second clock signal CLK2 having the high level H to the sixth node N6 in response to the voltage of the fifth node N5. Thus, the voltage of the sixth node N6 may have the high level H.

The seventh, ninth and fourteenth transistors T7, T9 and T14 may be turned off in response to the voltage of the first node N1. Thus, the thirteenth transistor T13 may be turned off in response to the second clock signal CLK2, the voltage of the first node N1 may have the high level H, and the voltage of the second node N2 may be maintained at a previous level, or the low level L.

The fourth transistor T4 may be turned off in response to the voltage of the first node N1 having the high level H. Thus, the third transistor T3 may be turned on in response to the voltage of the second node N2 having the low level L, and may output the first clock signal CLK1 having the low level L as the scan signal GW. Accordingly, in the first time period TP1, the stage 200 may output the scan signal GW having the low level L.

Referring to FIGS. 5 and 7, in a second time period TP2 in which the input signal SIN has the high level H, in which the first clock signal CLK1 has the high level H, and in which the second clock signal CLK2 has the low level L, the fifth transistor T5 may be turned off in response to the first clock signal CLK1, the sixth transistor T6 may be turned on in response to the concurrent driving signal GCK, and the voltage of the third node N3 and the voltage of the first node N1 may have the high level H.

The eighth transistor T8 may be turned off in response to the first clock signal CLK1, the seventh, ninth and fourteenth transistors T7, T9 and T14 may be turned off in response to the voltage of the first node N1, the tenth transistor T10 may be turned on in response to the first low gate voltage VGL, and the voltage of the fourth node N4 and the voltage of the fifth node N5 may have the low level L.

The eleventh and twelfth transistors T11 and T12 may transfer the second clock signal CLK2 having the low level L to the sixth node N6 in response to the voltage of the fifth node N5. Thus, the voltage of the sixth node N6 may have the low level L.

The thirteenth transistor T13 may be turned on in response to the second clock signal CLK2, and may transfer the voltage of the sixth node N6 to the second node N2. Thus, the voltage of the first node N1 may have the high level H, and the voltage of the second node N2 may have the low level L.

The fourth transistor T4 may be turned off in response to the voltage of the first node N1 having the high level H. The third transistor T3 may be turned on in response to the voltage of the second node N2 having the low level L, and may output the first clock signal CLK1 having the high level H as the scan signal GW. Accordingly, in the second time period TP2, the stage 200 may output the scan signal GW having the high level H.

Referring to FIGS. 5 and 8, in a third time period TP3 in which the input signal SIN has the low level L, in which the first clock signal CLK1 has the low level L, and in which the second clock signal CLK2 has the high level H, the fifth transistor T5 may be turned on in response to the first clock signal CLK1, and may transfer the input signal SIN having the low level L to the third node N3. Thus, the voltage of the third node N3 may have the low level L.

The sixth transistor T6 may be turned on in response to the concurrent driving signal GCK, and may transfer the voltage of the third node N3 to the first node N1. Thus, the voltage of the first node N1 may have the low level L.

The eighth transistor T8 may be turned on in response to the first clock signal CLK1, the seventh, ninth and fourteenth transistors T7, T9 and T14 may be turned on in response to the voltage of the first node N1, the tenth transistor T10 may be turned on in response to the first low gate voltage VGL, the eleventh and twelfth transistors T11 and T12 may be turned on in response to the voltage of the fifth node N5, and the thirteenth transistor T13 may be turned off in response to the second clock signal CLK2. Thus, the voltage of the fourth node N4 may have the low level L based on the concurrent driving signal GCK and the first clock signal CLK1, the voltage of the fifth node N5 may have the low level L based on the voltage of the fourth node N4, the voltage of the sixth node N6 may have the high level H based on the second clock signal CLK2, and the voltage of the second node N2 may have the low level L based on the first clock signal CLK1.

In some embodiments, when the first clock signal CLK1 applied to the first electrode of the third capacitor C3 decreases from the high level H to the low level L, then the voltage of the second node N2 connected to the second electrode of the third capacitor C3 may be boosted.

The third transistor T3 may be turned on in response to the voltage of the second node N2 having the low level L, and may output the first clock signal CLK1 having the low level L as the scan signal GW. Further, the fourth transistor T4 may be turned on in response to the voltage of the first node N1 having the low level L, and may output the concurrent driving signal GCK having the low level L as the scan signal GW. Accordingly, in the third time period TP3, the stage 200 may output the scan signal GW having the low level L.

In this way, in the progressive driving period PDP, the stage 200 or the (4N+1)-th stage STG1, STG5, etc. illustrated in FIG. 1 may output the scan signal GW, GW[1], GW[5], etc. in synchronization with the first clock signal CLK1, the (4N+2)-th stage STG2, etc. illustrated in FIG. 1 may output the scan signal GW[2], etc. in synchronization with the second clock signal CLK2, the (4N+3)-th stage STG3, etc. illustrated in FIG. 1 may output the scan signal GW[3], etc. in synchronization with the third clock signal CLK3, and the (4N+4)-th stage STG4, etc. illustrated in FIG. 1 may output the scan signal GW[4], etc. in synchronization with the fourth clock signal CLK4. Therefore, the scan driver according to embodiments may sequentially output the scan signals GW, GW[1], GW[2], GW[3], GW[4], GW[5], etc. having the high level H by using the PMOS transistors in the progressive driving period PDP.

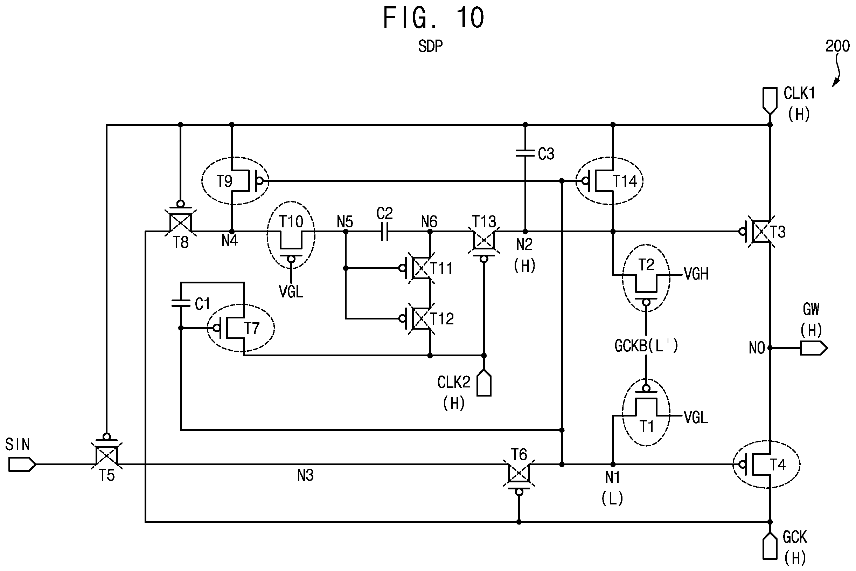

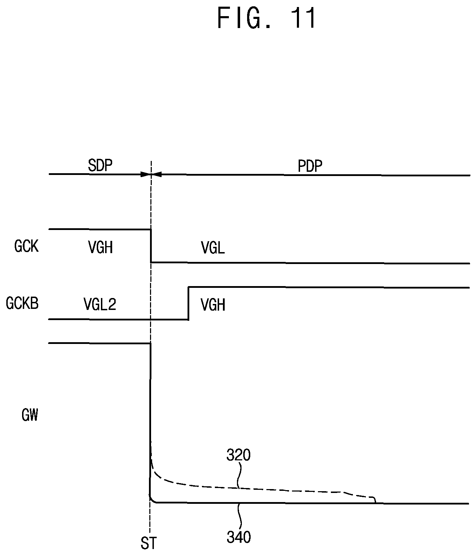

FIG. 9 is a timing diagram for describing an example of an operation of a stage of FIG. 4 in a concurrent driving period, FIG. 10 is a circuit diagram for describing an example of an operation of a stage of FIG. 4 in a concurrent driving period, and FIG. 11 is a timing diagram for describing an example of a scan signal at a time point at which a concurrent driving period ends and a progressive driving period starts.

Referring to FIGS. 4 and 9, in the concurrent driving period SDP, the first and second clock signals CLK1 and CLK2 may be maintained at the high level H, the concurrent driving signal GCK may have the high gate voltage VGH as the high level H, and the inverted concurrent driving signal GCKB may have the second low gate voltage VGL2 that is lower than the first low gate voltage VGL as the low level L'.

During the concurrent driving period SDP, all stages of the scan driver may substantially simultaneously output the scan signal GW having the high level H based on the concurrent driving signal GCK having the high level H or the high gate voltage VGH, and based on the inverted concurrent driving signal GCKB having the low level L' or the second low gate voltage VGL2. For example, in response to the inverted concurrent driving signal GCKB, the concurrent driving circuit 270 of the stage 200 may apply the first low gate voltage VGL to the first node N1, and may apply the high gate voltage VGH to the second node N2. Further, the output circuit 260 of the stage 200 may output the concurrent driving signal GCK having the high level H or the high gate voltage VGH as the scan signal GW in response to the voltage of the first node N1 having the low level L and in response to the voltage of the second node N2 having the high level H.

For example, referring to FIGS. 9 and 10, the sixth transistor T6 may be turned off in response to the concurrent driving signal GCK, and the thirteenth transistor T13 may be turned off in response to the second clock signal CLK2. Thus, the voltage of the third node N3 may not affect the voltage of the first node N1, and the voltage of the sixth node N6 may not affect the voltage of the second node N2.

The fifth and eighth transistors T5 and T8 may be turned off in response to the first clock signal CLK1, the seventh, ninth and fourteenth transistors T7, T9 and T14 may be turned on in response to the voltage of the first node N1, the tenth transistor T10 may be turned on in response to the first low gate voltage VGL, and the eleventh and twelfth transistors T11 and T12 may be turned off in response to the voltage of the fifth node N5.

Further, the first transistor T1 may be turned on in response to the inverted concurrent driving signal GCKB having the low level L' or the second low gate voltage VGL2, and may transfer the first low gate voltage VGL to the first node N1. Thus, the voltage of the first node N1 may have the low level L. Further, the second transistor T2 may be turned on in response to the inverted concurrent driving signal GCKB having the low level L' or the second low gate voltage VGL2, and may transfer the high gate voltage VGH to the second node N2. Thus, the voltage of the second node N2 may have the high level H.

The third transistor T3 may be turned off in response to the voltage of the second node N2 having the high level H, and the fourth transistor T4 may be turned on in response to the voltage of the first node N1 having the low level L. Thus, the fourth transistor T4 may output the concurrent driving signal GCK having the high level H or the high gate voltage VGH as the scan signal GW. Accordingly, during the concurrent driving period SDP, the stage 200 may output the scan signal GW having the high level H.

In some embodiments, at an end time point of the concurrent driving period SDP, or at a start time point of the progressive driving period PDP, the concurrent driving signal GCK may change from the high gate voltage VGH to the first low gate voltage VGL, and the inverted concurrent driving signal GCKB may change from the second low gate voltage VGL2 to the high gate voltage VGH.

In other embodiments, as illustrated in FIG. 11, the concurrent driving signal GCK may change from the high gate voltage VGH to the first low gate voltage VGL at the end time point of the concurrent driving period SDP, or at the start time point ST of the progressive driving period PDP. Further, within the progressive driving period PDP, the inverted concurrent driving signal GCKB may change from the second low gate voltage VGL2 to the high gate voltage VGH after a corresponding amount of time has passed from when the concurrent driving signal GCK changes to the first low gate voltage VGL. Accordingly, at the end time point of the concurrent driving period SDP, or at the start time point ST of the progressive driving period PDP, the scan signal GW may rapidly fall from the high level H to the low level L.

Further, in a case where the inverted concurrent driving signal GCKB has the first low gate voltage VGL during the concurrent driving period SDP, the voltage of the first node N1 may not have a sufficiently low level L during the concurrent driving period SDP, the fourth transistor T4 may not be sufficiently turned on in an initial portion of the progressive driving period PDP, and a voltage level 320 of the scan signal GW may not reach a voltage level of the first low gate voltage VGL in the initial portion of the progressive driving period PDP. However, in the scan driver according to embodiments, the inverted concurrent driving signal GCKB may have the second low gate voltage VGL2 that is lower than the first low gate voltage VGL during the concurrent driving period SDP, the voltage of the first node N1 may have a sufficiently low level L during the concurrent driving period SDP, the fourth transistor T4 may be sufficiently or completely turned on in the initial portion of the progressive driving period PDP, and the voltage level 340 of the scan signal GW may rapidly reach the voltage level of the first low gate voltage VGL in the initial portion of the progressive driving period PDP.

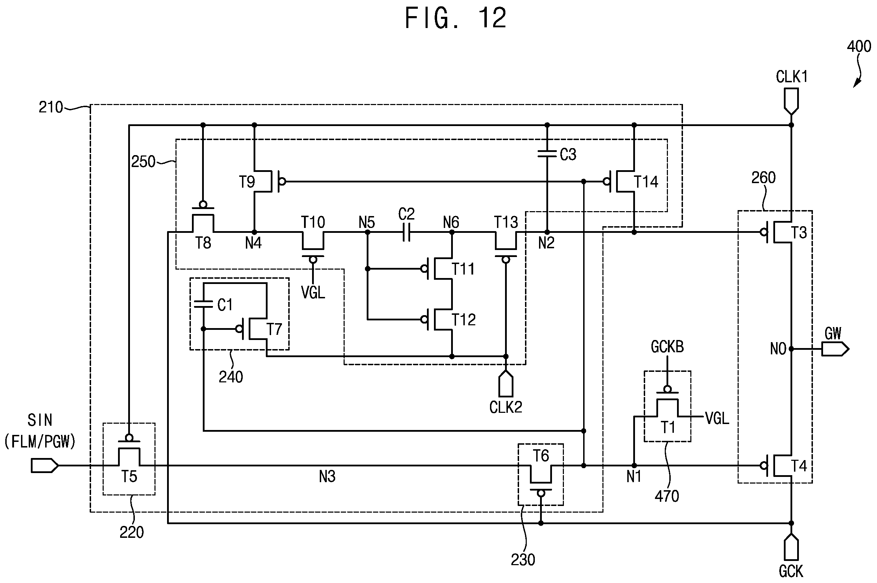

FIG. 12 is a circuit diagram illustrating a stage of a scan driver according to embodiments.

Referring to FIG. 12, a stage 400 of a scan driver according to embodiments may include a logic circuit 210, an output circuit 260, and a concurrent driving circuit 470. The logic circuit 210 may include an input circuit 220, a node-separating circuit 230, a boosting circuit 240, and a node control circuit 250. The stage 400 of FIG. 12 may have substantially the same configuration and substantially the same operation as a stage 200 of FIG. 4, except that the concurrent driving circuit 470 may omit a second transistor T2 illustrated in FIG. 4, and instead may include only a first transistor T1.

In a concurrent driving period, the first transistor T1 may be turned on in response to an inverted concurrent driving signal GCKB having a second low gate voltage, and may transfer a first low gate voltage VGL to a first node N1. Thus, a voltage of the first node N1 may have a low level.

Further, in the concurrent driving period, a fourteenth transistor T14 may be turned on in response to the voltage of the first node N1 having the low level, and may transfer a first clock signal CLK1 having a high level to a second node N2. Thus, a voltage of the second node N2 may have the high level. Accordingly, even if the concurrent driving circuit 470 does not include the second transistor T2 illustrated in FIG. 4, in the concurrent driving period, the concurrent driving circuit 470 may control the voltage of the first node N1 to the low level, and may control the voltage of the second node N2 to the high level by using the fourteenth transistor T14.

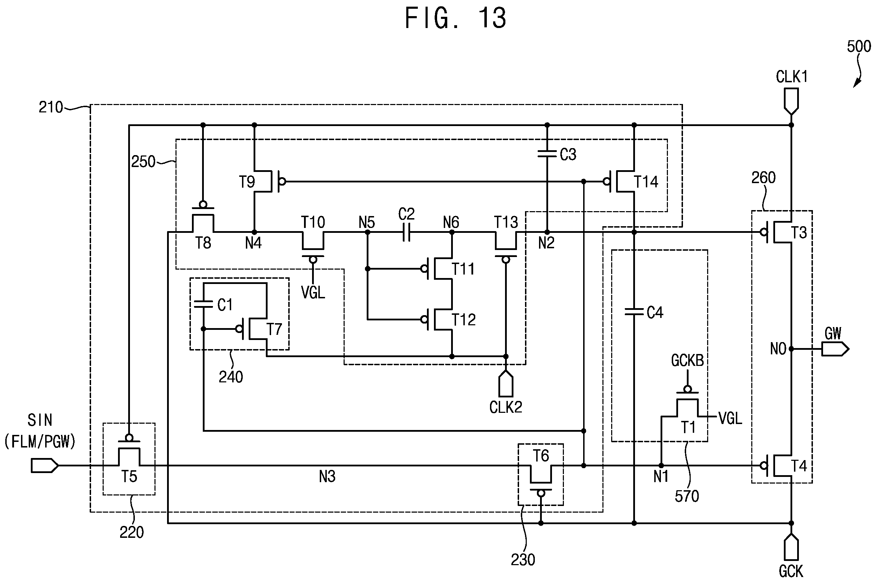

FIG. 13 is a circuit diagram illustrating a stage of a scan driver according to embodiments.

Referring to FIG. 13, a stage 500 of a scan driver according to embodiments may include a logic circuit 210, an output circuit 260, and a concurrent driving circuit 570. The logic circuit 210 may include an input circuit 220, a node-separating circuit 230, a boosting circuit 240, and a node control circuit 250. The stage 500 of FIG. 13 may have substantially the same configuration and substantially the same operation as a stage 400 of FIG. 12, except that the concurrent driving circuit 570 may further include a fourth capacitor C4.

The fourth capacitor C4 may be connected between a second node N2 and a line that transfers a concurrent driving signal GCK. In some embodiments, the fourth capacitor C4 may include a first electrode connected to the second node N2, and a second electrode that receives the concurrent driving signal GCK. Thus, when the concurrent driving signal GCK applied to the second electrode of the fourth capacitor C4 increases from a first low gate voltage VGL to a high gate voltage VGH at a start time point of a concurrent driving period, a voltage of the second node N2 connected to the first electrode of the fourth capacitor C4 also may increase due to coupling of the fourth capacitor C4. Accordingly, in the concurrent driving period, the concurrent driving circuit 570 may control the voltage of the first node N1 to a low level, and may rapidly control the voltage of the second node N2 to a high level.

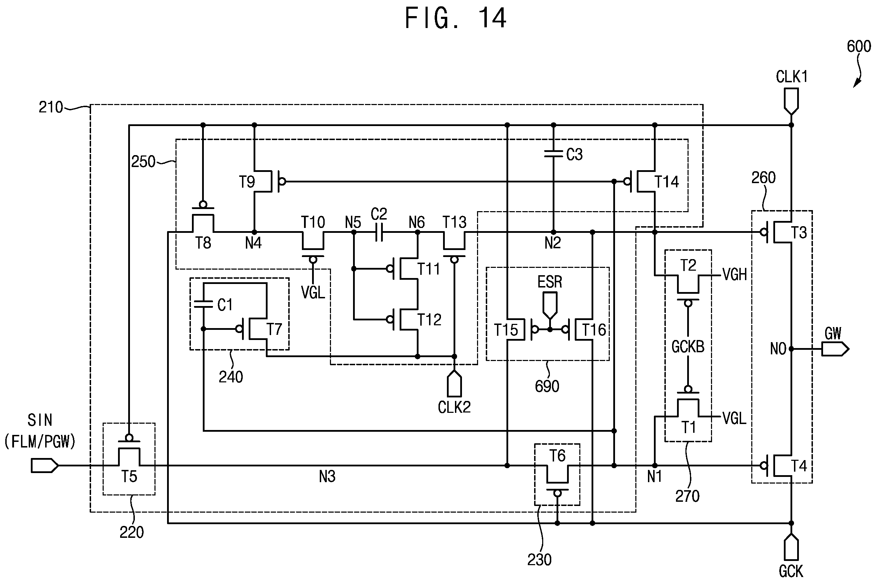

FIG. 14 is a circuit diagram illustrating a stage of a scan driver according to embodiments.

Referring to FIG. 14, a stage 600 of a scan driver according to embodiments may include a logic circuit 210, an output circuit 260, a concurrent driving circuit 270, and a reset circuit 690. The logic circuit 210 may include an input circuit 220, a node-separating circuit 230, a boosting circuit 240, and a node control circuit 250. The stage 600 of FIG. 14 may have substantially the same configuration and substantially the same operation as a stage 200 of FIG. 4, except that the stage 600 may further include the reset circuit 690.

The reset circuit 690 may transfer a first clock signal CLK1 to a first node N1 in response to a reset signal ESR, and may transfer a concurrent driving signal GCK to a second node N2 in response to the reset signal ESR. In some embodiments, when a display device is powered on, the reset signal ESR may have a low level. Thus, when the display device is powered on, in response to the reset signal ESR having the low level, the reset circuit 690 may reset a voltage of the first node N1 based on the first clock signal CLK1, and may reset the voltage of the second node N2 based on the concurrent driving signal GCK.

In some embodiments, the reset circuit 690 may include a fifteenth transistor T15 that transfers the first clock signal CLK1 to the first node N1 through a sixth transistor T6 in response to the reset signal ESR, and a sixteenth transistor T16 that transfers the concurrent driving signal GCK to the second node N2 in response to the reset signal ESR. For example, the fifteenth transistor T15 may include a gate that receives the reset signal ESR, a first terminal that receives the first clock signal CLK1, and a second terminal connected to a third node N3.

Although FIG. 14 illustrates an example in which the second terminal of the fifteenth transistor T15 is connected to the third node N3, and in which the first clock signal CLK1 is transferred to the first node N1 through the sixth transistor T6, in other embodiments, the second terminal of the fifteenth transistor T15 may be connected to the first node N1. Further, the sixteenth transistor T16 may include a gate that receives the reset signal ESR, a first terminal connected to the second node N2, and a second terminal that receives the concurrent driving signal GCK.

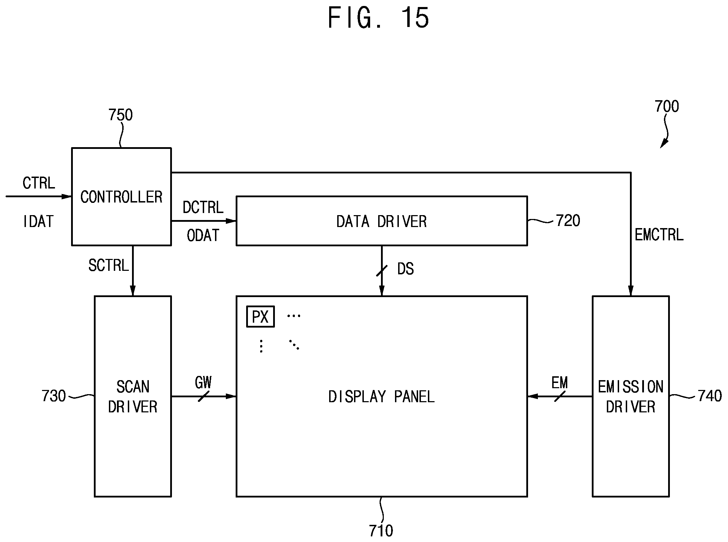

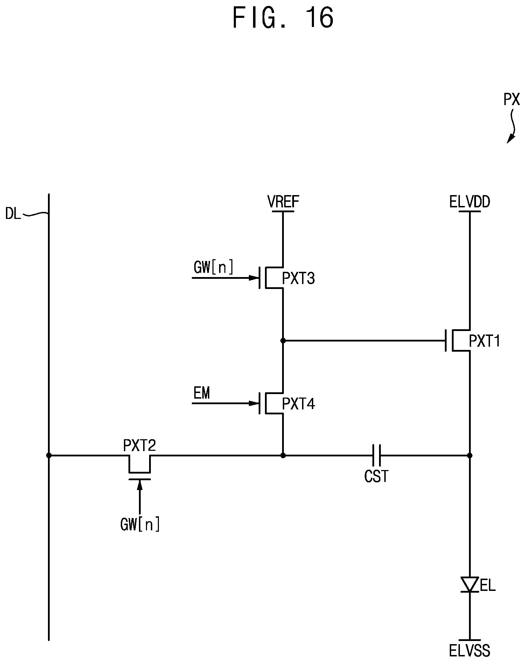

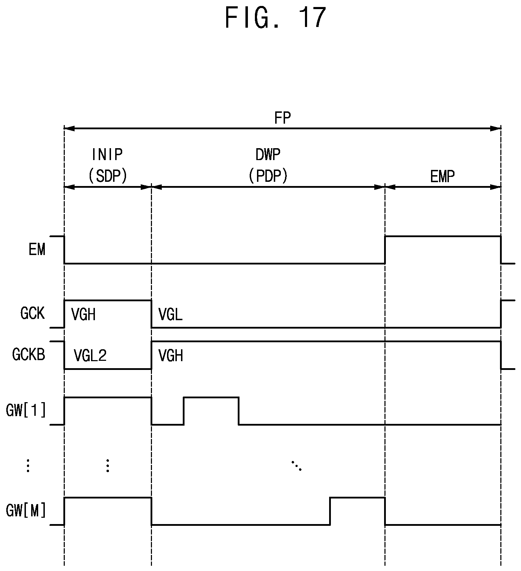

FIG. 15 is a block diagram illustrating a display device according to embodiments, FIG. 16 is a circuit diagram illustrating an example of a pixel included in a display device according to embodiments, and FIG. 17 is a timing diagram illustrating an example of a frame period of a display device.

Referring to FIG. 15, a display device 700 according to embodiments may include a display panel 710 including a plurality of pixels PX, a data driver 720 that provides data signals DS to the plurality of pixels PX, a scan driver 730 that provides scan signals GW to the plurality of pixels PX, an emission driver 740 that provides emission signals EM to the plurality of pixels PX, and a controller 750 that controls the data driver 720, the scan driver 730, and the emission driver 740.

The display panel 710 may include data lines, scan lines, emission lines, and the plurality of pixels PX connected to the data lines, the scan lines, and the emission lines. In some embodiments, each pixel PX may include a light-emitting element, and the display panel 710 may be a light-emitting display panel. However, the display panel 710 is not limited to the light-emitting display panel, and may be any suitable display panel.

For example, as illustrated in FIG. 16, each pixel PX may include a first transistor PXT1, a second transistor PXT2, a third transistor PXT3, a fourth transistor PXT4, a storage capacitor CST, and a light-emitting element EL.

The first transistor PXT1 may generate a driving current based on a voltage stored in the storage capacitor CST. The first transistor PXT1 may be a driving transistor for driving the light-emitting element EL. In some embodiments, the first transistor PXT1 may include a gate connected to a gate node, a first terminal that receives a first power supply voltage ELVDD (e.g., a high power supply voltage), and a second terminal connected to a source node.

The storage capacitor CST may store the data signal DS transferred through the second transistor PXT2. In some embodiments, the storage capacitor CST may include a first electrode connected to the second and fourth transistors PXT2 and PXT4, and a second electrode connected to the source node.

The second transistor PXT2 may connect the data line DL to the storage capacitor CST in response to the scan signal GW[n]. In some embodiments, the second transistor PXT2 may include a gate that receives the scan signal GW[n], a first terminal connected to the data line DL, and a second terminal connected to the storage capacitor CST.

The third transistor PXT3 may transfer a reference voltage VREF to the gate node in response to the scan signal GW[n]. In some embodiments, the reference voltage VREF may have a voltage level for turning on the first transistor PXT1. Further, in some embodiments, the third transistor PXT3 may include a gate that receives the scan signal GW[n], a first terminal that receives the reference voltage VREF, and a second terminal connected to the gate node.

The fourth transistor PXT4 may connect the storage capacitor CST to the gate node in response to the emission signal EM. In some embodiments, the fourth transistor PXT4 may include a gate that receives the emission signal EM, a first terminal connected to the gate node, and a second terminal connected to the storage capacitor CST.

The light-emitting element EL may emit light based on the driving current generated by the first transistor PXT1. In some embodiments, the light-emitting element EL may be, but is not limited to, an organic light-emitting diode ("OLED"). In other embodiments, the light-emitting element EL may be a micro light-emitting diode, a nano light-emitting diode ("NED"), a quantum dot ("QD") light-emitting diode, an inorganic light-emitting diode, or any other suitable light-emitting element. Further, in some embodiments, the light-emitting element EL may include an anode connected to the first transistor PXT1, and a cathode that receives a second power supply voltage ELVSS (e.g., a low power supply voltage).

In some embodiments, as illustrated in FIG. 16, the first, second, third, and fourth transistors PXT1, PXT2, PXT3, and PXT4 may be, but are not limited to, N-type metal-oxide-semiconductor ("NMOS") transistors. Although FIG. 16 illustrates an example in which the pixel PX has a 4T1C structure, the pixel PX of the display device 700 according to embodiments is not limited to the example of FIG. 16.

Referring to FIG. 15, the data driver 720 may generate the data signals DS based on a data control signal DCTRL, may output image data ODAT received from the controller 750, and may provide the data signals DS to the plurality of pixels PX through the data lines. In some embodiments, the data control signal DCTRL may include, but is not limited to, an output data enable signal, a horizontal start signal, and a load signal. In some embodiments, the data driver 720 and the controller 750 may be implemented as a single integrated circuit, and the single integrated circuit may be referred to as a timing controller embedded data driver ("TED") integrated circuit. In other embodiments, the data driver 720 and the controller 750 may be implemented as separate integrated circuits.

The scan driver 730 may generate the scan signals GW based on a scan control signal SCTRL received from the controller 750, and may provide the scan signals GW to the plurality of pixels PX through the scan lines. In some embodiments, the scan control signal SCTRL can include, but is not limited to, a start signal FLM, a first clock signal CLK1, a second clock signal CLK2, a third clock signal CLK3, a fourth clock signal CLK4, a concurrent driving signal GCK, and an inverted concurrent driving signal GCKB illustrated in FIG. 1. The scan driver 730 may be a scan driver 100 of FIG. 1 including a stage 200 of FIG. 4, a stage 400 of FIG. 12, a stage 500 of FIG. 13, a stage 600 of FIG. 14, or the like. Thus, the scan driver 730 may generate the scan signals GW for turning on the second and third transistors PXT2 and PXT3, which are the NMOS transistors, of the pixels PX by using PMOS transistors. Further, the scan driver 730 may sequentially provide the scan signals GW to the plurality of pixels PX on a row-by-row basis in a progressive driving period, and may substantially simultaneously provide the scan signals GW to the plurality of pixels PX in a concurrent driving period. Further, in some embodiments, the scan driver 730 may be integrated or formed in the display panel 710. In other embodiments, the scan driver 730 may be implemented with one or more integrated circuits.

The emission driver 740 may generate the emission signals EM based on an emission control signal EMCTRL received from the controller 750, and may provide the emission signals EM to the plurality of pixels PX through the emission lines. In some embodiments, the emission driver 740 may substantially simultaneously provide the emission signals EM to the plurality of pixels PX. In other embodiments, the emission driver 740 may sequentially provide the emission signals EM to the plurality of pixels PX on a row-by-row basis. Further, in some embodiments, the emission driver 740 may be integrated or formed in the display panel 710. In other embodiments, the emission driver 740 may be implemented with one or more integrated circuits.

The controller 750 (e.g., a timing controller) may receive input image data IDAT and a control signal CTRL from a processor (e.g., a graphics processing unit ("GPU"), an application processor ("AP") or a graphics card). In some embodiments, the input image data IDAT may be RGB image data including red image data, green image data, and blue image data. In some embodiments, the control signal CTRL may include, but is not limited to, a vertical synchronization signal, a horizontal synchronization signal, an input data enable signal, a master clock signal, etc. The controller 750 may generate the output image data ODAT, the data control signal DCTRL, the scan control signal SCTRL, and the emission control signal EMCTRL based on the input image data IDAT and the control signal CTRL. The controller 750 may control an operation of the data driver 720 by providing the output image data ODAT and the data control signal DCTRL to the data driver 720, may control an operation of the scan driver 730 by providing the scan control signal SCTRL to the scan driver 730, and may control an operation of the emission driver 740 by providing the emission control signal EMCTRL to the emission driver 740.

In the display device 700 according to embodiments, a frame period may include a concurrent driving period in which the scan driver 730 substantially simultaneously provides the scan signals GW to the plurality of pixels PX, and a progressive driving period (or a sequential driving period) in which the scan driver 730 sequentially provides the scan signals GW to the plurality of pixels PX on a row-by-row basis.

For example, as illustrated in FIG. 17, the frame period FP may include an initialization period INIP in which gate nodes and source nodes of the plurality of pixels PX are initialized, a data writing period DWP in which the data signals DS are sequentially written to the plurality of pixels PX on a row-by-row basis, and an emission period EMP in which the plurality of pixels PX substantially simultaneously emits light. Further, the initialization period INIP may be the concurrent driving period SDP in which the scan driver 730 substantially simultaneously provides the scan signals GW[1], ..., GW[M] to the plurality of pixels PX, and the data writing period DWP may be the progressive driving period PDP in which the scan driver 730 sequentially provides the scan signals GW[1], ..., GW[M] to the plurality of pixels PX on a row-by-row basis. Further, in an example illustrated in FIG. 17, the emission signal EM may be a global signal that is substantially simultaneously applied to the plurality of pixels PX.

For example, in the initialization period INIP, the emission signal EM may have a low level, the concurrent driving signal GCK may have a high gate voltage VGH, and the inverted concurrent driving signal GCKB may have a second low gate voltage VGL2. Thus, the scan driver 730 may substantially simultaneously provide the scan signals GW[1], ..., GW[M] having high levels to the plurality of pixels PX based on the concurrent driving signal GCK and the inverted concurrent driving signal GCKB.

In each pixel PX, the second and third transistors PXT2 and PXT3 may be turned on in response to the scan signal GW[n] having the high level, and the first transistor PXT1 may be turned on based on the reference voltage VREF transferred through the third transistor PXT3 to the gate node. Thus, the gate node may be initialized based on the reference voltage VREF, and the source node may be initialized based on the first power supply voltage ELVDD.

In the data writing period DWP, the emission signal EM may have a low level, the concurrent driving signal GCK may have a first low gate voltage VGL, and the inverted concurrent driving signal GCKB may have the high gate voltage VGH. The scan driver 730 may sequentially provide the scan signals GW[1], ..., GW[M] having the high level to the plurality of pixels PX on a row-by-row basis based on the concurrent driving signal GCK and based on the inverted concurrent driving signal GCKB. For example, in a case where the display panel 710 has first through M-th pixel rows, where M is an integer greater than 1, the scan driver 730 may sequentially output first through M-th scan signals GW[1], ..., GW[M] in an order from a first scan signal GW[1] for the first pixel row to an M-th scan signal GW[M] for the M-th pixel row. In a pixel PX is an n-th pixel row, where n is an integer greater than or equal to 1 and less than or equal to M, when an n-th scan signal GW[n] having a high level is applied, the third transistor PXT3 may transfer the reference voltage VREF to the gate node, the first transistor PXT1 may be turned on until a voltage of the source node becomes a voltage obtained by subtracting a threshold voltage of the first transistor PXT1 from the reference voltage VREF, and the second transistor PXT2 may apply the data signal DS to the first electrode of the storage capacitor CST. Thus, the storage capacitor CST may store the data signal DS in which the threshold voltage of the first transistor PXT1 is reflected or compensated.

In the emission period EMP, the emission signal EM may have a high level. In each pixel PX, the fourth transistor PXT4 may connect the storage capacitor CST to the gate node, the first transistor PXT1 may generate the driving current based on the data signal DS stored in the storage capacitor CST, and the light-emitting element EL may emit light based on the driving current.

As described above, in the display device 700 according to embodiments, the scan driver 730 may generate the scan signals GW for turning on the NMOS transistors of each pixel PX by using PMOS transistors. Further, in the display device 700 according to embodiments, the scan driver 730 may sequentially provide the scan signals GW to the plurality of pixels PX on a row-by-row basis in the progressive driving period PDP, and may substantially simultaneously provide the scan signals GW to the plurality of pixels PX in the concurrent driving period SDP.

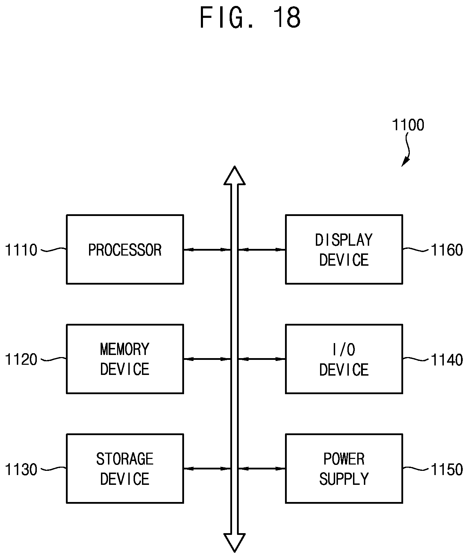

FIG. 18 is a block diagram illustrating an electronic device including a display device according to embodiments.

Referring to FIG. 18, an electronic device 1100 may include a processor 1110, a memory device 1120, a storage device 1130, an input/output (I/O) device 1140, a power supply 1150 and a display device 1160. The electronic device 1100 may further include a plurality of ports for communicating with a video card, a sound card, a memory card, a universal serial bus ("USB") device, other electric devices, etc.

The processor 1110 may perform various computing functions or tasks. The processor 1110 may be an application processor ("AP"), a micro-processor, a central processing unit ("CPU"), etc. The processor 1110 may be coupled to other components via an address bus, a control bus, a data bus, etc. Further, in some embodiments, the processor 1110 may be further coupled to an extended bus such as a peripheral component interconnection ("PCI") bus.

The memory device 1120 may store data for operations of the electronic device 1100. For example, the memory device 1120 may include at least one non-volatile memory device such as an erasable programmable read-only memory ("EPROM") device, an electrically erasable programmable read-only memory ("EEPROM") device, a flash memory device, a phase change random access memory ("PRAM") device, a resistance random access memory ("RRAM") device, a nano floating gate memory ("NFGM") device, a polymer random access memory ("PoRAM") device, a magnetic random access memory ("MRAM") device, and/or a ferroelectric random access memory ("FRAM") device, etc., and/or at least one volatile memory device such as a dynamic random access memory ("DRAM") device, a static random access memory ("SRAM") device, and/or a mobile dynamic random access memory ("mobile DRAM") device, etc.

The storage device 1130 may be a solid state drive ("SSD") device, a hard disk drive ("HDD") device, a compact disc-read only memory ("CD-ROM") device, etc. The I/O device 1140 may be an input device, such as a keyboard, a keypad, a mouse, a touch screen, etc., and an output device, such as a printer, a speaker, etc. The power supply 1150 may supply power for operations of the electronic device 1100. The display device 1160 may be coupled to other components through the buses or other communication links.

In the display device 1160, a scan driver 730 may generate scan signals for turning on NMOS transistors of each pixel by using PMOS transistors. Further, in the display device 1160, the scan driver may sequentially provide the scan signals to a plurality of pixels on a row-by-row basis in a progressive driving period, and may substantially simultaneously provide the scan signals to the plurality of pixels in a concurrent driving period.

The disclosed embodiments may be applied any electronic device 1100 including the display device 1160. For example, the disclosed embodiments may be applied to a virtual reality ("VR") device, an augmented reality ("AR") device, a mixed reality ("MR") device, an extended reality ("XR") device, a mobile phone, a smart phone, a television ("TV") (e.g., a digital TV, a three-dimensional ("3D") TV, etc.), a wearable electronic device, a personal computer ("PC") (e.g. a laptop computer, a tablet computer, etc.), a home appliance, a personal digital assistant ("PDA"), a portable multimedia player ("PMP"), a digital camera, a music player, a portable game console, a navigation device, etc.

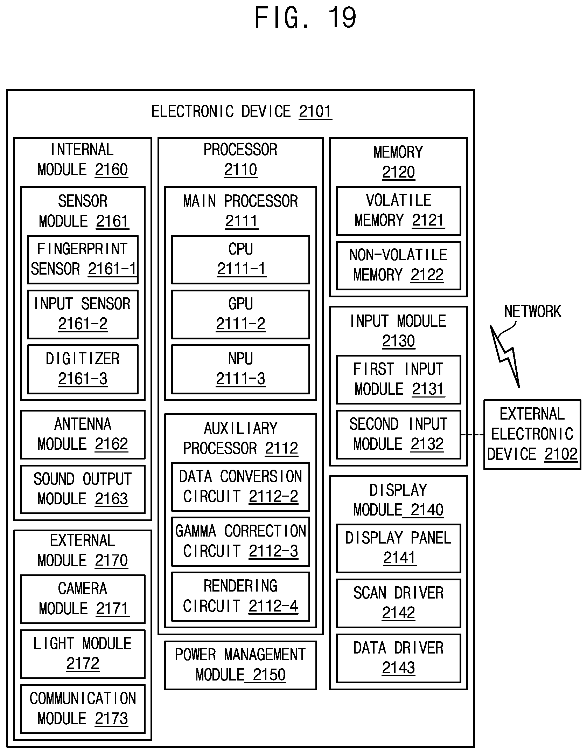

FIG. 19 is a block diagram illustrating an example of an electronic device according to embodiments.

An electronic device 2101 may output various information via a display module 2140 in an operating system. When a processor 2110 executes an application stored in a memory 2120, the display module 2140 may provide application information to a user via a display panel 2141.

The processor 2110 may obtain an external input via an input module 2130 or a sensor module 2161 and may execute an application corresponding to the external input. For example, when the user selects a camera icon displayed on the display panel 2141, the processor 2110 may obtain a user input via an input sensor 2161-2 and may activate a camera module 2171. The processor 2110 may transfer image data corresponding to an image captured by the camera module 2171 to the display module 2140. The display module 2140 may display an image corresponding to the captured image via the display panel 2141.

As another example, when personal information authentication is executed in the display module 2140, a fingerprint sensor 2161-1 may obtain input fingerprint information as input data. The processor 2110 may compare the input data obtained by the fingerprint sensor 2161-1 with authentication data stored in the memory 2120, and may execute an application according to the comparison result. The display module 2140 may display information executed according to application logic via the display panel 2141.

As still another example, when a music streaming icon displayed on the display module 2140 is selected, the processor 2110 obtains a user input via the input sensor 2161-2 and may activate a music streaming application stored in the memory 2120. When a music execution command is input in the music streaming application, the processor 2110 may activate a sound output module 2163 to provide sound information corresponding to the music execution command to the user.

In the above, an operation of the electronic device 2101 has been briefly described. Hereinafter, a configuration of the electronic device 2101 will be described in detail. Some components of the electronic device 2101 described below may be integrated and provided as one component, or one component may be provided separately as two or more components.

Referring to FIG. 19, the electronic device 2101 may communicate with an external electronic device 2102 via a network (e.g., a short-range wireless communication network or a long-range wireless communication network). In some embodiments, the electronic device 2101 may include the processor 2110, the memory 2120, the input module 2130, the display module 2140, a power management module 2150, an internal module 2160, and/or an external module 2170. In some embodiments, at least one of the components may be omitted from the electronic device 2101, or one or more other components may be added in the electronic device 2101. In some embodiments, some of the components (e.g., the sensor module 2161, an antenna module 2162, or the sound output module 2163) may be implemented as a single component (e.g., the display module 2140).

The processor 2110 may execute software to control at least one other component (e.g., a hardware or software component) of the electronic device 2101 coupled with the processor 2110, and may perform various data processing or computation. According to some embodiments, as at least part of the data processing or computation, the processor 2110 may store a command or data received from another component (e.g., the input module 2130, the sensor module 2161 or a communication module 2173) in a volatile memory 2121, may process the command or the data stored in the volatile memory 2121, and may store resulting data in a non-volatile memory 2122.

The processor 2110 may include a main processor 2111 and an auxiliary processor 2112. The main processor 2111 may include one or more of a central processing unit ("CPU") 2111-1 or an application processor ("AP"). The main processor 2111 may further include any one or more of a graphics processing unit ("GPU") 2111-2, a communication processor ("CP"), and an image signal processor ("ISP"). The main processor 2111 may further include a neural processing unit ("NPU") 2111-3. The NPU 2111-3 may be a processor specialized in processing an artificial intelligence model, and the artificial intelligence model may be generated through machine learning. The artificial intelligence model may include a plurality of artificial neural network layers. The artificial neural network may be a deep neural network ("DNN"), a convolutional neural network ("CNN"), a recurrent neural network ("RNN"), a restricted Boltzmann machine ("RBM"), a deep belief network ("DBN"), a bidirectional recurrent deep neural network ("BRDNN"), deep Q-network or a combination of two or more thereof, but is not limited thereto. The artificial intelligence model may, additionally or alternatively, include a software structure other than a hardware structure. At least two of the above-described processing units and processors may be implemented as an integrated component (e.g., a single chip), or respective processing units and processors may be implemented as independent components (e.g., a plurality of chips).

The auxiliary processor 2112 may include a controller. The controller included in the auxiliary processor 2112 may correspond to a controller 750 illustrated in FIG. 15. The controller may include an interface conversion circuit and a timing control circuit. The controller may receive an image signal from the main processor 2111, may convert a data format of the image signal to meet interface specifications with the display module 2140, and may output image data. The controller may output various control signals required for driving the display module 2140.

The auxiliary processor 2112 may further include a data conversion circuit 2112-2, a gamma correction circuit 2112-3, a rendering circuit 2112-4, or the like. The data conversion circuit 2112-2 may receive image data from the controller. The data conversion circuit 2112-2 may compensate for the image data such that an image is displayed with a desired luminance according to characteristics of the electronic device 2101 or the user's setting, or may convert the image data to reduce power consumption or to eliminate an afterimage. The gamma correction circuit 2112-3 may convert image data or a gamma reference voltage so that an image displayed on the electronic device 2101 has desired gamma characteristics. The rendering circuit 2112-4 may receive image data from the controller, and may render the image data in consideration of a pixel arrangement of the display panel 2141 in the electronic device 2101. At least one of the data conversion circuit 2112-2, the gamma correction circuit 2112-3 and the rendering circuit 2112-4 may be integrated in another component (e.g., the main processor 2111 or the controller). At least one of the data conversion circuit 2112-2, the gamma correction circuit 2112-3, and the rendering circuit 2112-4 may be integrated in a data driver 2143 described below.

The memory 2120 may store various data used by at least one component (e.g., the processor 2110 or the sensor module 2161) of the electronic device 2101. The various data may include, for example, input data or output data for a command related thereto. The memory 2120 may include at least one of the volatile memory 2121 and/or the non-volatile memory 2122.

The input module 2130 may receive a command or data to be used by the components (e.g., the processor 2110, the sensor module 2161, or the sound output module 2163) of the electronic device 2101 from the outside of the electronic device 2101 (e.g., the user or the external electronic device 2102).

The input module 2130 may include a first input module 2131 for receiving a command or data from the user, and a second input module 2132 for receiving a command or data from the external electronic device 2102. The first input module 2131 may include a microphone, a mouse, a keyboard, a key (e.g., a button) or a pen (e.g., a passive pen or an active pen). The second input module 2132 may support a designated protocol capable of connecting the electronic device 2101 to the external electronic device 2102 by wire or wirelessly. In some embodiments, the second input module 2132 may include a high definition multimedia interface ("HDMI"), a universal serial bus ("USB") interface, an SD card interface or an audio interface. The second input module 2132 may include a connector that may physically connect the electronic device 2101 to the external electronic device 2102. For example, the second input module 2132 may include an HDMI connector, a USB connector, an SD card connector, or an audio connector (e.g., a headphone connector).

The display module 2140 may visually provide information to the user. The display module 2140 may include the display panel 2141, a scan driver 2142, and the data driver 2143. The display module 2140 may further include a window, a chassis, and a bracket for protecting the display panel 2141.

The display panel 2141 may include a liquid crystal display panel, an organic light emitting display panel or an inorganic light emitting display panel, but the type of the display panel 2141 is not limited thereto. The display panel 2141 may be a rigid type display panel, or a flexible type display panel capable of being rolled or folded. The display module 2140 may further include a supporter, a bracket or a heat dissipation member that supports the display panel 2141.

The scan driver 2142 may be mounted on the display panel 2141 as a driving chip. Alternatively, the scan driver 2142 may be integrated into the display panel 2141. For example, the scan driver 2142 may include an amorphous silicon TFT gate driver circuit ("ASG"), a low temperature polycrystalline silicon ("LTPS") TFT gate driver circuit, or an oxide semiconductor TFT gate driver circuit ("OSG") embedded in the display panel 2141. The scan driver 2142 may receive a control signal from the controller, and may output scan signals to the display panel 2141 in response to the control signal.

In some embodiments, the scan driver 2142 may generate scan signals for turning on NMOS transistors of each pixel by using PMOS transistors. Further, the scan driver 2142 may sequentially provide the scan signals to a plurality of pixels on a row-by-row basis in a progressive driving period, and may substantially simultaneously provide the scan signals to the plurality of pixels in a concurrent driving period.

The display panel 2141 may further include an emission driver. The emission driver may output an emission control signal to the display panel 2141 in response to a control signal received from the controller. The emission driver may be formed separately from the scan driver 2142, or may be integrated into the scan driver 2142.

The data driver 2143 may receive a control signal from the controller, may convert image data into analog voltages (e.g., data voltages) in response to the control signal, and then may output the data voltages to the display panel 2141.

The data driver 2143 may be incorporated into other components (e.g., the controller). Further, the functions of the interface conversion circuit and the timing control circuit of the controller described above may be integrated into the data driver 2143.

The display module 2140 may further include the emission driver, a voltage generator circuit, or the like. The voltage generator circuit may output various voltages used to drive the display panel 2141.

The power management module 2150 may supply power to the components of the electronic device 2101. The power management module 2150 may include a battery that charges a power supply voltage. The battery may include a primary cell that is not rechargeable, a secondary cell that is rechargeable, or a fuel cell. The power management module 2150 may include a power management integrated circuit ("PMIC"). The PMIC may supply optimal power to each of the modules described above and modules described below. The power management module 2150 may include a wireless power transmission/reception member electrically connected to the battery. The wireless power transmission/reception member may include a plurality of antenna radiators in the form of coils.

The electronic device 2101 may further include the internal module 2160 and the external module 2170. The internal module 2160 may include the sensor module 2161, the antenna module 2162 and the sound output module 2163. The external module 2170 may include the camera module 2171, a light module 2172, and the communication module 2173.

The sensor module 2161 may detect an input by the user's body or an input by the pen of the first input module 2131, and may generate an electrical signal or data value corresponding to the input. The sensor module 2161 may include at least one of the fingerprint sensor 2161-1, the input sensor 2161-2, and/or a digitizer 2161-3.

The fingerprint sensor 2161-1 may generate a data value corresponding to the user's fingerprint. The fingerprint sensor 2161-1 may include any one of an optical type fingerprint sensor and/or a capacitive type fingerprint sensor.

The input sensor 2161-2 may generate a data value corresponding to coordinate information of the user's body input or the pen input. The input sensor 2161-2 may convert a capacitance change caused by the input into the data value. The input sensor 2161-2 may detect the input by the passive pen, or may transmit/receive data to/from the active pen.

The input sensor 2161-2 may measure a bio-signal, such as blood pressure, moisture or body fat. For example, when a portion of the body of the user touches a sensor layer or a sensing panel, and does not move for a corresponding period of time, the input sensor 2161-2 may output information desired by the user to the display module 2140 by detecting the bio-signal based on a change in electric field due to the portion of the body.

The digitizer 2161-3 may generate a data value corresponding to coordinate information of the input by the pen. The digitizer 2161-3 may convert an amount of an electromagnetic change caused by the input into the data value. The digitizer 2161-3 may detect the input by the passive pen, or may transmit/receive data to/from the active pen.

At least one of the fingerprint sensor 2161-1, the input sensor 2161-2, and the digitizer 2161-3 may be implemented as a sensor layer formed on the display panel 2141 through a continuous process. The fingerprint sensor 2161-1, the input sensor 2161-2, and the digitizer 2161-3 may be above the display panel 2141, or at least one of the fingerprint sensor 2161-1, the input sensor 2161-2, and/or the digitizer 2161-3 may be below the display panel 2141.

Two or more of the fingerprint sensor 2161-1, the input sensor 2161-2 and the digitizer 2161-3 may be integrated into one sensing panel through the same process. When integrated into one sensing panel, the sensing panel may be between the display panel 2141 and a window above the display panel 2141. In some embodiments, the sensing panel may be on the window, but the location of the sensing panel is not limited thereto.

At least one of the fingerprint sensor 2161-1, the input sensor 2161-2, and the digitizer 2161-3 may be embedded in the display panel 2141. In other words, at least one of the fingerprint sensor 2161-1, the input sensor 2161-2, and/or the digitizer 2161-2 may be substantially simultaneously formed through a process of forming elements (e.g., light emitting elements, transistors, etc.) included in the display panel 2141.

In addition, the sensor module 2161 may generate an electrical signal or a data value corresponding to an internal state or an external state of the electronic device 2101. The sensor module 2161 may further include, for example, a gesture sensor, a gyro sensor, an atmospheric pressure sensor, a magnetic sensor, an acceleration sensor, a grip sensor, a proximity sensor, a color sensor, an infrared ("IR") sensor, a biometric sensor, a temperature sensor, a humidity sensor, or an illuminance sensor.

The antenna module 2162 may include one or more antennas for transmitting/receiving a signal/power to/from the outside. In some embodiments, the communication module 2173 may transmit or receive a signal to or from the external electronic device 2102 through an antenna suitable for a communication method. An antenna pattern of the antenna module 2162 may be integrated into one component (e.g., the display panel 2141) of the display module 2140 or the input sensor 2161-2.

The sound output module 2163 may output sound signals to the outside of the electronic device 2101. The sound output module 2163 may include, for example, a speaker or a receiver. The speaker may be used for general purposes, such as playing multimedia or playing record. The receiver may be used for receiving incoming calls. In some embodiments, the receiver may be implemented as separate from, or as part of the speaker. A sound output pattern of the sound output module 2163 may be integrated into the display module 2140.

The camera module 2171 may capture a still image and a moving image. In some embodiments, the camera module 2171 may include one or more lenses, an image sensor or an image signal processor. The camera module 2171 may further include an infrared camera capable of measuring the presence or absence of the user, the user's location and the user's line of sight.

The light module 2172 may provide light. The light module 2172 may include a light emitting diode or a xenon lamp. The light module 2172 may operate in conjunction with the camera module 2171, or may operate independently of the camera module 2171.

The communication module 2173 may support establishing a wired or wireless communication channel between the electronic device 2101 and the external electronic device 2102 and performing communication via the established communication channel. The communication module 2173 may include a wireless communication module (e.g., a cellular communication module, a short-range wireless communication module or a global navigation satellite system ("GNSS") communication module) or a wired communication module (e.g., a local area network ("LAN") communication module or a power line communication ("PLC") module). The communication module 2173 may communicate with the external electronic device 2102 via a short-range communication network (e.g., Bluetooth^{®}, wireless-fidelity (Wi-Fi^{®}) direct, or infrared data association ("IrDA"), Bluetooth^{®} being a registered trademark of Bluetooth Sig, Inc., Kirkland, WA, and Wi-Fi^{®} being a registered trademark of the non-profit Wi-Fi Alliance) or a long-range communication network (e.g., a cellular network, the Internet or a computer network (e.g., LAN or wide area network ("WAN"))). These various types of communication modules 2173 may be implemented as a single chip, or may be implemented as multi-chips separate from each other.

The input module 2130, the sensor module 2161, the camera module 2171, and the like may be used to control an operation of the display module 2140 in conjunction with the processor 2110.

The processor 2110 may output a command or data to the display module 2140, the sound output module 2163, the camera module 2171 or the light module 2172 based on input data received from the input module 2130. For example, the processor 2110 may generate image data corresponding to input data applied through a mouse or an active pen, and may output the image data to the display module 2140. Alternatively, the processor 2110 may generate command data corresponding to the input data, and may output the command data to the camera module 2171 or the light module 2172. When no input data is received from the input module 2130 for a corresponding period of time, the processor 2110 may switch an operation mode of the electronic device 2101 to a low power mode or a sleep mode, thereby reducing power consumption of the electronic device 2101.

The processor 2110 may output a command or data to the display module 2140, the sound output module 2163, the camera module 2171 or the light module 2172 based on sensing data received from the sensor module 2161. For example, the processor 2110 may compare authentication data applied by the fingerprint sensor 2161-1 with authentication data stored in the memory 2120, and then may execute an application according to the comparison result. The processor 2110 may execute a command or output corresponding image data to the display module 2140 based on the sensing data sensed by the input sensor 2161-2 or the digitizer 2161-3. In a case where the sensor module 2161 includes a temperature sensor, the processor 2110 may receive temperature data from the sensor module 2161, and may further perform luminance correction on the image data based on the temperature data.

The processor 2110 may receive measurement data about the presence or absence of the user, the location of the user and the user's line of sight from the camera module 2171. The processor 2110 may further perform luminance correction on the image data based on the measurement data. For example, after the processor 2110 determines the presence or absence of the user based on the input from the camera module 2171, the data conversion circuit 2112-2 or the gamma correction circuit 2112-3 may perform the luminance correction on the image data, and the processor 2110 may provide the luminance-corrected image data to the display module 2140.

At least some of the above-described components may be coupled mutually and communicate signals (e.g., commands or data) therebetween via an inter-peripheral communication scheme (e.g., a bus, general purpose input and output ("GPIO"), serial peripheral interface ("SPI"), mobile industry processor interface ("MIPI") or ultra-path interconnect ("UPI")). The processor 2110 may communicate with the display module 2140 via an agreed interface. Further, any one of the above-described communication methods may be used between the processor 2110 and the display module 2140, but the communication method between the processor 2110 and the display module 2140 is not limited to the above-described communication method.

The electronic device 2101 according to various embodiments described above may be various types of devices. For example, the electronic device 2101 may include at least one of a portable communication device (e.g., a smart phone), a computer device, a portable multimedia device, a portable medical device, a camera, a wearable device, and/or a home appliance. However, the electronic device 2101 according to embodiments is not limited to the above-described devices.
The foregoing is illustrative of embodiments and is not to be construed as limiting thereof. Although some embodiments have been described, those skilled in the art will readily appreciate that many modifications are possible in the embodiments without materially departing from the novel teachings and aspects of the present disclosure. Accordingly, all such modifications are intended to be included within the scope of the present disclosure as defined in the claims. Therefore, it is to be understood that the foregoing is illustrative of various embodiments and is not to be construed as limited to the embodiments disclosed, and that modifications to the disclosed embodiments, as well as other embodiments, are intended to be included within the scope of the appended claims, with functional equivalents thereof to be included therein.

## Claims

1. A scan driver comprising stages, at least one stage of the stages comprising:
a logic circuit configured to control a voltage of a first node and a voltage of a second node based on an input signal, a first clock signal, and a second clock signal in a progressive driving period;
an output circuit configured to receive the first clock signal and a concurrent driving signal, and to output a scan signal in response to the voltage of the first node and the voltage of the second node; and
a concurrent driving circuit configured to control the voltage of the first node and the voltage of the second node in response to an inverted concurrent driving signal in a concurrent driving period such that the output circuit is configured to output the concurrent driving signal as the scan signal in the concurrent driving period.

2. The scan driver of claim 1, wherein the concurrent driving signal has a first low gate voltage in the progressive driving period, and has a high gate voltage in the concurrent driving period, and
wherein the inverted concurrent driving signal has the high gate voltage in the progressive driving period, and has a second low gate voltage that is lower than the first low gate voltage in the concurrent driving period.

3. The scan driver of claim 2, wherein the concurrent driving signal is changed from the high gate voltage to the first low gate voltage at a start time point of the progressive driving period, and
wherein, within the progressive driving period, the inverted concurrent driving signal is changed from the second low gate voltage to the high gate voltage after the concurrent driving signal is changed to the first low gate voltage.

4. The scan driver of any preceding claim, wherein, in the concurrent driving period:
the concurrent driving circuit is configured to apply a first low gate voltage to the first node, and a high gate voltage to the second node, in response to the inverted concurrent driving signal; and
the output circuit is configured to output the concurrent driving signal having the high gate voltage as the scan signal.

5. The scan driver of any preceding claim, wherein, in the progressive driving period:
the logic circuit is configured to control the voltage of the first node to a high level, and is configured to control the voltage of the second node to a low level, when the first clock signal has the low level and the input signal has the high level; and
the output circuit is configured to output the first clock signal as the scan signal in response to the voltage of the first node having the high level and the voltage of the second node having the low level.

6. The scan driver of any preceding claim, wherein all transistors in the at least one stage comprise P-type metal-oxide-semiconductor (PMOS) transistors.

7. The scan driver of any preceding claim, wherein the concurrent driving circuit comprises a first transistor comprising a gate configured to receive the inverted concurrent driving signal, a first terminal configured to receive a first low gate voltage, and a second terminal connected to the first node.

8. The scan driver of claim 7, wherein the concurrent driving circuit further comprises a second transistor comprising a gate configured to receive the inverted concurrent driving signal, a first terminal configured to receive a high gate voltage, and a second terminal connected to the second node.

9. The scan driver of claim 7 or claim 8, wherein the concurrent driving circuit further comprises a fourth capacitor comprising a first electrode connected to the second node, and a second electrode configured to receive the concurrent driving signal.

10. The scan driver of any preceding claim, wherein the output circuit comprises:
a third transistor comprising a gate connected to the second node, a first terminal configured to receive the first clock signal, and a second terminal connected to an output node configured to output the scan signal; and
a fourth transistor comprising a gate connected to the first node, a first terminal connected to the output node, and a second terminal configured to receive the concurrent driving signal.

11. The scan driver of any preceding claim, wherein the logic circuit comprises:
an input circuit configured to transfer the input signal to a third node in response to the first clock signal;
a node-separating circuit between the third node and the first node;
a boosting circuit configured to boost the voltage of the first node based on the second clock signal; and
a node control circuit configured to control the voltage of the second node based on the first clock signal, the second clock signal, the voltage of the first node, and the concurrent driving signal.

12. The scan driver of claim 11, wherein the input circuit comprises a fifth transistor comprising a gate configured to receive the first clock signal, a first terminal configured to receive the input signal, and a second terminal connected to the third node.

13. The scan driver of claim 11 or claim 12, wherein the node-separating circuit comprises a sixth transistor comprising a gate configured to receive the concurrent driving signal, a first terminal connected to the third node, and a second terminal connected to the first node.

14. The scan driver of any of claims 11 to 13, wherein the boosting circuit comprises:
a seventh transistor comprising a gate connected to the first node, a first terminal, and a second terminal configured to receive the second clock signal; and
a first capacitor comprising a first electrode connected to the first terminal of the seventh transistor, and a second electrode connected to the first node.

15. The scan driver of any of claims 11 to 14, wherein the node control circuit comprises:
an eighth transistor comprising a gate configured to receive the first clock signal, a first terminal configured to receive the concurrent driving signal, and a second terminal connected to a fourth node;
a ninth transistor comprising a gate connected to the first node, a first terminal configured to receive the first clock signal, and a second terminal connected to the fourth node;
a tenth transistor comprising a gate configured to receive a first low gate voltage, a first terminal connected to the fourth node, and a second terminal connected to a fifth node;
a second capacitor comprising a first electrode connected to the fifth node, and a second electrode connected to a sixth node;
an eleventh transistor comprising a gate connected to the fifth node, a first terminal connected to the sixth node, and a second terminal;
a twelfth transistor comprising a gate connected to the fifth node, a first terminal connected to the second terminal of the eleventh transistor, and a second terminal configured to receive the second clock signal;
a thirteenth transistor comprising a gate configured to receive the second clock signal, a first terminal connected to the sixth node, and a second terminal connected to the second node;
a third capacitor comprising a first electrode configured to receive the first clock signal, and a second electrode connected to the second node; and
a fourteenth transistor comprising a gate connected to the first node, a first terminal configured to receive the first clock signal, and a second terminal connected to the second node.

16. The scan driver of any preceding claim, wherein the at least one stage further comprises a reset circuit configured to transfer the first clock signal to the first node in response to a reset signal, and to transfer the concurrent driving signal to the second node in response to the reset signal.

17. The scan driver of claim 16, wherein the reset circuit comprises:
a fifteenth transistor comprising a gate configured to receive the reset signal, a first terminal configured to receive the first clock signal, and a second terminal connected to a third node; and
a sixteenth transistor comprising a gate configured to receive the reset signal, a first terminal connected to the second node, and a second terminal configured to receive the concurrent driving signal.

18. A scan driver comprising stages, at least one stage of the stages comprising:
a logic circuit configured to receive an input signal, a first clock signal, a second clock signal, and a concurrent driving signal, and connected to a first node and to a second node;
a first transistor comprising a gate configured to receive an inverted concurrent driving signal, a first terminal configured to receive a first low gate voltage, and a second terminal connected to the first node;
a second transistor comprising a gate configured to receive the inverted concurrent driving signal, a first terminal configured to receive a high gate voltage, and a second terminal connected to the second node;
a third transistor comprising a gate connected to the second node, a first terminal configured to receive the first clock signal, and a second terminal connected to an output node configured to output a scan signal; and
a fourth transistor comprising a gate connected to the first node, a first terminal connected to the output node, and a second terminal configured to receive the concurrent driving signal.

19. The scan driver of claim 18, wherein the logic circuit comprises:
a fifth transistor comprising a gate configured to receive the first clock signal, a first terminal configured to receive the input signal, and a second terminal connected to a third node;
a sixth transistor comprising a gate configured to receive the concurrent driving signal, a first terminal connected to the third node, and a second terminal connected to the first node;
a seventh transistor comprising a gate connected to the first node, a first terminal, and a second terminal configured to receive the second clock signal;
a first capacitor comprising a first electrode connected to the first terminal of the seventh transistor, and a second electrode connected to the first node;
an eighth transistor comprising a gate configured to receive the first clock signal, a first terminal configured to receive the concurrent driving signal, and a second terminal connected to a fourth node;
a ninth transistor comprising a gate connected to the first node, a first terminal configured to receive the first clock signal, and a second terminal connected to the fourth node;
a tenth transistor comprising a gate configured to receive the first low gate voltage, a first terminal connected to the fourth node, and a second terminal connected to a fifth node;
a second capacitor comprising a first electrode connected to the fifth node, and a second electrode connected to a sixth node;
an eleventh transistor comprising a gate connected to the fifth node, a first terminal connected to the sixth node, and a second terminal;
a twelfth transistor comprising a gate connected to the fifth node, a first terminal connected to the second terminal of the eleventh transistor, and a second terminal configured to receive the second clock signal;
a thirteenth transistor comprising a gate configured to receive the second clock signal, a first terminal connected to the sixth node, and a second terminal connected to the second node;
a third capacitor comprising a first electrode configured to receive the first clock signal, and a second electrode connected to the second node; and
a fourteenth transistor comprising a gate connected to the first node, a first terminal configured to receive the first clock signal, and a second terminal connected to the second node.

20. An electronic device comprising:
a processor configured to provide input image data; and
a display device configured to receive the input image data from the processor, and to display an image based on the input image data, the display device comprising:
a display panel comprising pixels;
a data driver configured to provide data signals to the pixels;
a scan driver comprising stages configured to provide scan signals to the pixels;
an emission driver configured to provide emission signals to the pixels; and
a controller configured to control the data driver, the scan driver and the emission driver,
wherein at least one stage of the stages comprises:
a logic circuit configured to control a voltage of a first node and a voltage of a second node based on an input signal, a first clock signal, and a second clock signal in a progressive driving period;
an output circuit configured to receive the first clock signal and a concurrent driving signal, and to output a scan signal in response to the voltage of the first node and the voltage of the second node; and
a concurrent driving circuit configured to control the voltage of the first node and the voltage of the second node in response to an inverted concurrent driving signal in a concurrent driving period such that the output circuit is configured to output the concurrent driving signal as the scan signal in the concurrent driving period.
